(19)

**Europäisches Patentamt**

**European Patent Office**

**Office européen des brevets**

(11) **EP 4 542 289 A1**

(12) **EUROPEAN PATENT APPLICATION**
published in accordance with Art. 153(4) EPC

(43) Veröffentlichungstag:
**23.04.2025  Patentblatt 2025/17**

(21) Anmeldenummer: **24834585.2**

(22) Anmeldetag: **08.08.2024**

(51) Internationale Patentklassifikation (IPC):
*G02F 1/01* (2006.01)

(52) Gemeinsame Patentklassifikation (CPC):
**G01J 9/02; G02F 1/01; H01S 3/00; H01S 3/137**

(86) Internationale Anmeldenummer:
**PCT/JP2024/028367**

(87) Internationale Veröffentlichungsnummer:
**WO 2025/033482 (13.02.2025 Gazette 2025/07)**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **09.08.2023  JP 2023129744**

(71) Anmelder: **Magnescale Co., Ltd.**
**Isehara-shi, Kanagawa 259-1146 (JP)**

(72) Erfinder: **TANAKA, Akira**
**Isehara-shi**
**Kanagawa**
**2591146 (JP)**

(74) Vertreter: **Isarpatent**
**Patent- und Rechtsanwälte**
**Barth Hassa Peckmann & Partner mbB**
**Friedrichstraße 31**
**80801 München (DE)**

(54) **FERNKALIBRIERUNGSSYSTEM FÜR OPTISCHE FREQUENZ**

(57)  Umfasst sind eine Slave-Kalibriereinheit (200-N), die mit mindestens einer zu kalibrierenden Lichtquelle ausgestattet ist, eine Master-Kalibriereinheit (300), die mittels einer optischen Frequenzkammvorrichtung die Frequenz einer zu kalibrierenden Lichtquelle, mit der die Slave-Kalibriereinheit (200-N) ausgestattet ist, misst und kalibriert, und eine optische Übertragungseinheit (110), welche die Slave-Kalibriereinheit (200-N) und die Master-Kalibriereinheit (300) verbindet. Die Master-Kalibriereinheit (300) kalibriert eine optische Frequenz des Ausgangslichts der zu kalibrierenden Lichtquelle der Slave-Kalibriereinheit (200-N), das über die optische Übertragungseinheit (110) übertragen wurde, mittels der optischen Frequenzkammvorrichtung, wobei sie die optische Frequenz bezüglich der elektrischen Ausgabe eines Schwebungssignals des Ausgangslichts der optischen Frequenzkammvorrichtung und des Ausgangslichts der zu kalibrierenden Lichtquelle misst und kalibriert. Ferner stabilisiert die Master-Kalibriereinheit (300) basierend auf einem auf der Basis von Zeit und Frequenznormen fernkalibrierfähigen RF-Oszillator die Betriebsfrequenz der optischen Frequenzkammvorrichtung.

Fig. 1

**Beschreibung**

**Technisches Gebiet**

Die vorliegende Erfindung betrifft ein Kalibriersystem, durch das eine optische Frequenz einer zu kalibrierenden Lichtquelle, die in einer Slave-Kalibriereinheit vorgesehen ist, mittels einer optischen Frequenzkammvorrichtung kalibriert wird, die in einer Master-Kalibriereinheit vorgesehen ist.

**Hintergrundtechnologie**

Als Technologie, durch die mit hoher Präzision die optische Frequenz einer Laserlichtquelle gemessen/kalibriert wird, ist die Nutzung eines Verfahrens weit verbreitet, bei dem ein Schwebungssignal verwendet wird, das durch eine Interferenz von Ausgangslicht einer optischen Frequenzkammvorrichtung und Ausgangslicht der zu kalibrierenden Lichtquelle entsteht. Als stellvertretendes Beispiel hierfür kann Patentdokument 1 angeführt werden. Im Patentdokument 1 wird ein Mittel bereitgestellt, durch das basierend auf der Frequenz eines Schwebungssignals, das durch eine Interferenz des Ausgangslichts einer einzelnen zu messenden Lichtquelle und des Ausgangslichts einer an die zu messende Lichtquelle angenäherten optischen Frequenzkammvorrichtung erhalten wird, der Wiederholfrequenz und einer Träger-Einhüllenden-Offsetfrequenz (CEO, Carrier-Envelope-Offset) der optischen Frequenzkammvorrichtung und einer durch Messung der optischen Frequenz der zu messenden Lichtquelle mit einem Wellenmesser ermittelten Modenordnung die optische Frequenz mit einer hohen Präzision ermittelt wird. Im Patentdokument 2 wird ein Verfahren bereitgestellt, bei dem ebenfalls ein Schwebungssignal eines mit einer optischen Frequenzkammvorrichtung synchronisierten Offsetlasers und einer zu messenden Lichtquelle hinzugefügt und für eine Kalibrierung ohne Verwendung eines Wellenmessers genutzt wird. Im Nicht-Patentdokument 1 wird ein Verfahren bereitgestellt, bei dem ohne Verwendung eines Wellenmessers mittels eines Lasers mit einer Frequenzunsicherheit, die kleiner ist als der Modenabstand einer optischen Frequenzkammvorrichtung, die Modenordnung der optischen Frequenzkammvorrichtung festgelegt wird.

**Dokumente des Standes der Technik**

**Patentdokumente**

Patentdokument 1: Patentveröffentlichung Nr. JP 2015-5601 A
Patentdokument 2: Patentveröffentlichung Nr. JP 2014-190759 A

**Nicht-Patentdokumente**

Nicht-Patentdokument 1: Hajime Inaba et al., "Frequency Measurement Capability of a Fiber-Based Frequency Comb at 633 nm", IEEE TRANSACTIONS ON INSTRUMENTATION AND MEASUREMENT, VOL. 58, NO. 4, 1234, APRIL 2009.

**Übersicht über die Erfindung**

**Durch die Erfindung zu lösende Aufgabe**

Einschließlich der Patentdokumente 1 und 2 wurde jedoch bisher von einer Operation ausgegangen, bei der vorausgesetzt wird, dass die optische Frequenz einer einzelnen zu kalibrierenden Lichtquelle, die im gleichen Raum wie eine optische Frequenzkammvorrichtung eingerichtet ist, kalibriert wird, während ein dezentrales Kalibrierverfahren, bei dem eine an einem entfernten Ort eingerichtete zu kalibrierende Lichtquelle aus der Ferne kalibriert wird, und dazu noch ein Kalibrierverfahren, bei dem eine Mehrzahl von zu kalibrierenden Lichtquellen, die an einer Mehrzahl von entfernten Orten eingerichtet sind, wahlweise oder gleichzeitig kalibriert werden können, bisher nicht diskutiert wurde.

Andererseits wird es in letzter Zeit in der Industriewelt, insbesondere in der herstellenden Industrie, immer wichtiger, durch einen Paradigmenwechsel zu einer "Industrie 4,0", durch die Remotebefehle/-bedienung von Fabrikanlagen und eine Digitalisierung von Einrichtungs-/Prüfdaten gefördert und die Produktivität extrem erhöht wird, die Profitabilität und internationale Wettbewerbsfähigkeit von Betrieben zu steigern.

Bei den vorstehenden bisherigen Kalibriersystemen für optische Frequenzen ist es jedoch erforderlich, die Lichtquelle des Kalibrierobjekts aus der Anlage, bei der sie verwendet wird, zu entnehmen, zu einer Kalibriereinheit zu transportieren, welche mit einer optischen Frequenzkammvorrichtung zur Durchführung der Kalibrierung ausgestattet ist, und anschließend den Kalibrierprozess durchzuführen, sodass das Problem besteht, dass zusätzlich zum Arbeitsschritt der Kalibrierung, begleitende Arbeitsschritte wie das Entnehmen und Anbringen sowie der Transport der zu kalibrierenden Lichtquelle erforderlich sind, wodurch sich eine für die Kalibrierung erforderliche lange Durchlaufzeit ergibt. Konkret wird die zu kalibrierende Lichtquelle aus der Anlage, bei der sie verwendet wird, entnommen und zu einer Kalibriereinheit transportiert, welche mit einer optischen Frequenzkammvorrichtung zur Durchführung der Kalibrierung ausgestattet ist, und anschließend in der Nähe der optischen Frequenzkammvorrichtung eingerichtet, woraufhin ein Aufwärmen der Lichtquelle und die Ausführung der Kalibrierung erfolgt. Ist die Kalibrierung beendet, erfolgt eine Prozedur, bei der die zu kalibrierende Lichtquelle erneut entnommen, wieder zur ursprünglichen Anlage transportiert und in der betreffenden Anlage angebracht wird, dann ein Aufwärmen und eine optische Einstellung der Lichtquelle durchgeführt und anschließend die Anlage wieder in Betrieb genommen wird.

Herkömmlichen Kalibriersysteme für optische Frequenzen haben daher einen die Produktivität einer Fabrik schädigenden Aspekt. Bei einer Mehrzahl von zu kalibrierenden Lichtquellen ist ferner für jede in einzelnen Schritten manuell ein Entnehmen, Transportieren, Anbringen und Aufwärmen erforderlich, wodurch eine Zunahme von Arbeitsstunden und Ausfallzeiten der Anlage verursacht wird. Außerdem benötigt das gegenwärtige Kalibrierverfahren mittels eines optischen Frequenzkamms eine langwierige Messung für die Kalibrierung einer einzigen Lichtquelle, wobei für jedes zu kalibrierende Gerät eine optische Frequenzkammvorrichtung betrieben werden muss.

Das technische Problem einer geringen optischen Leistung eines allgemeinen jodstabilisierten Helium-Neon (HeNe)-Lasers oder axialen Zeeman HeNe-Lasers als Kalibrierobjekt für Wellenmessgeräte im Wellenlängenband von 633 nm mit einer Ordnung von 0,1 mW, ist ein weiterer Hinderungsgrund, der einer Vergrößerung von Kalibriersystemen entgegensteht.

Der Reihe nach erläutert, ist zwar die Wellenlänge des Ausgangslichts eines HeNe-Lasers in der Nähe von 633 nm, die zentrale Wellenlänge des Ausgangslicht eines optischen Frequenzkamms, der einen Erbium-dotierten-Faserlaser als Oszillator verwendet, liegt jedoch in der Nähe von 1550 nm und ist von 633 entfernt, wobei auch bei einer Vergrößerung des Bandbereichs des optischen Frequenzkamms durch die Verwendung eines nicht-linearen optischen Effekts durch nicht-lineare Fasern bis zur Wellenlänge von 633 nm, die optische Leistung eines einzelnen vertikalen Modus einen geringen numerischen Wert einer Ordnung von einigen nW annehmen kann.

Wird daher die Schwebungsfrequenz eines vertikalen Modus der optischen Frequenz und der Ausgangsleistung der zu kalibrierenden Lichtquelle durch eine optische Konversion mittels eines Photodetektors gemessen, ist das Signal-Rausch-Verhältnis (S/N (Signal-to-Noise)-Verhältnis) gering, wobei beim Frequenzzähler das Problem eines Slip-Cycles entsteht, wenn das S/N-Verhältnis nicht größer oder gleich 30 dB ist, sodass der technische Hintergrund, dass die Frequenz nicht korrekt gemessen werden kann, dazu beiträgt, dass eine Frequenzmessung schwierig ist.

Daher können unter Berücksichtigung der aktuellen Situation, dass eine Erweiterung eines Kalibriersystem, bei dem die optischen Leistung einer optischen Frequenzkammvorrichtung räumlich getrennt, und ein jeweiliges Schwebungssignal des Ausgangslichts mit den jeweiligen zu kalibrierenden Lasern erworben wird, nicht möglich ist, und erst bei Verwendung der vollen Leistung des Ausgangslichts der optischen Frequenzkammvorrichtung eine Kalibrierung eines einzigen HeNe-Lasers technisch möglich ist, eine Mehrzahl von zu kalibrierenden Lasern nicht gleichzeitig kalibriert werden, sodass die gleichzeitige Ausführung einer Kalibrierung einer Mehrzahl von Lichtquellen nicht möglich ist.

Die vorliegende Erfindung erfolgte unter diesem Hintergrund und beabsichtigt als eine Aufgabe die Bereitstellung eines für eine Fernkalibrierung tauglichen Kalibriersystems, durch das die optische Frequenz des Ausgangslichts einer zu kalibrierenden Lichtquelle mittels einer optischen Frequenzkammvorrichtung, die an einer Stelle eingerichtet ist, die von der Stelle entfernt ist, an der die zu kalibrierende Lichtquelle aufgestellt ist, und als weitere Aufgabe die Bereitstellung eines dezentralen Kalibriersystems, durch das eine Mehrzahl von zu kalibrierenden Lichtquellen, die an einer Mehrzahl von entfernten Orten eingerichtet sind, wahlweise oder gleichzeitig kalibriert werden können.

**Mittel zum Lösen der Aufgabe**

Zum Lösen der vorstehenden Aufgaben, betrifft die vorliegende Erfindung ein Fernkalibriersystem für optische Frequenzen, umfassend

mindestens eine Slave-Kalibriereinheit, die mit mindestens einer zu kalibrierenden Lichtquelle ausgestattet ist,
eine Master-Kalibriereinheit, die an einer Stelle eingerichtet ist, die von der Stelle, an der die zu kalibrierende Lichtquelle eingerichtet ist, entfernt ist, mit einer optischen Frequenzkammvorrichtung ausgestattet ist, und mittels der optischen Frequenzkammvorrichtung die optische Frequenz der zu kalibrierenden Lichtquelle, mit der die Slave-Kalibriereinheit ausgestattet ist, misst und kalibriert,
und eine optische Übertragungseinheit, welche die Slave-Kalibriereinheit und die Master-Kalibriereinheit verbindet,
wobei es sich um einen Aufbau handelt, bei dem die Master-Kalibriereinheit eine optische Frequenz des Ausgangslichts der zu kalibrierenden Lichtquelle der Slave-Kalibriereinheit, das über die optische Übertragungseinheit übertragen wurde, mittels einer elektrischen Ausgabe eines Schwebungssignals des Ausgangslichts der optischen Frequenzkammvorrichtung und des Ausgangslichts der zu kalibrierenden Lichtquelle beim Kalibrieren mittels der optischen Frequenzkammvorrichtung misst und kalibriert, und eine Funktion aufweist, um basierend auf einem auf der Basis von Zeit- und Frequenznormen fernkalibrierfähigen RF-Oszillator die Betriebsfrequenz der optischen Frequenzkammvorrichtung zu stabilisieren.

Diesem Fernkalibriersystem zufolge sind die Slave-Kalibriereinheit und die Master-Kalibriereinheit über die optische Übertragungseinheit verbunden, sodass es zum Kalibrieren der optischen Frequenz der zu kalibrierenden Lichtquelle, die in der Slave-Kalibriereinheit vorgesehen ist, nicht erforderlich ist, die zu kalibrierende Lichtquelle in die Nähe der optischen Frequenzkammvorrichtung der Master-Kalibriereinheit zu transportieren und dort einzurichten, sondern die Kalibrierung durchgeführt werden kann, während die zu kalibrierende Lichtquelle in der Slave-Kalibriereinheit eingerichtet ist.

Folglich kann dem Fernkalibriersystem gemäß der vorliegenden Erfindung zufolge eine Kalibrierung der optischen Frequenz einer zu kalibrierenden Lichtquelle in kurzer Zeit und effizient durchgeführt werden.

Beim Fernkalibriersystem dieses Aspekts (erster Aspekt) kann ein Aspekt verwendet werden, bei dem die optische Frequenzkammvorrichtung einen Offsetlaser umfasst, auf den die Frequenzstabilität des optischen Frequenzkamms durch eine Phasensynchronisation übertragen wurde. Ferner kann die optische Übertragungseinheit aus einem optischen Übertragungsweg in Form einer optischen Faser oder eines Lichtleiters gebildet werden.

Das Fernkalibriersystem des ersten Aspekts kann außerdem einen Aspekt (zweiten Aspekt) verwenden, bei dem es eine Verwaltungseinheit mit der Funktion, einen Betriebszustand der Slave-Kalibriereinheit zu empfangen, der Funktion, einen Befehl zum Kalibrieren der zu kalibrierenden Lichtquelle an die Master-Kalibriereinheit zu senden, und der Funktion, ein Kalibrierergebnis von der Master-Kalibriereinheit zu empfangen, umfasst,

wobei die Slave-Kalibriereinheit die Funktion, den Betriebszustand an die Verwaltungseinheit zu senden, die Funktion, ein Umschaltsignal für einen optischen Pfad von der Master-Kalibriereinheit zu empfangen und die Funktion eines Verbindens mit dem Lichtleiter durch ein Umschalten des optischen Pfads des Ausgangslichts der zu kalibrierenden Lichtquelle hat,

und die Master-Kalibriereinheit die Funktion hat, wenn sie einen Kalibrierbefehl von der Verwaltungseinheit empfängt, einen Lichtweg-Umschaltbefehl an die Slave-Kalibriereinheit sendet und eine optische Frequenz des Ausgangslichts der zu kalibrierenden Lichtquelle, das von der Slave-Kalibriereinheit über den optischen Übertragungsweg übertragen wurde, mittels der optischen Frequenzkammvorrichtung kalibriert, unter Verwendung einer elektrischen Ausgabe eines Schwebungssignals des Ausgangslichts der optischen Frequenzkammvorrichtung und des Ausgangslichts der zu kalibrierenden Lichtquelle die optische Frequenz zu messen und zu kalibrieren, die Funktion, ein Kalibrierergebnis an eine Verwaltungskammer zu senden, und außerdem die Funktion hat, über GPS basierend auf einem auf der Basis von Zeit- und Frequenznormen fernkalibrierfähigen RF-Oszillator die Betriebsfrequenz der optischen Frequenzkammvorrichtung zu stabilisieren.

Ferner kann das Fernkalibriersystem des zweiten Aspekts einen Aspekt (dritten Aspekt) verwenden,

bei dem die Slave-Kalibriereinheit außerdem eine Kodierfunktion hat, durch die bei der optischen Frequenz des Ausgangslichts der zu kalibrierenden Lichtquelle mittels eines optischen Modulators eine Frequenzmodulation erfolgt, und sich ständig die Modulationsfrequenz ändert, die für jede zu kalibrierende Lichtquelle verschieden ist,

und die Master-Kalibriereinheit außerdem die Funktion aufweist, für die elektrische Ausgabe des Schwebungssignals des Ausgangslichts der optischen Frequenzkammvorrichtung und des Ausgangslichts der zu kalibrierenden Lichtquelle durch ein Mischen und Dekodieren der RF-Signale, die für die Kodierung des Ausgangslichts einer spezifischen zu kalibrierenden Lichtquelle aus der Mehrzahl von zu kalibrierenden Lichtquellen verwendet wurden, wahlweise die optische Frequenz zu messen und zu kalibrieren.

Ferner kann das Fernkalibriersystem des zweiten oder dritten Aspekts einen Aspekt (vierten Aspekt oder fünften Aspekt) verwenden,

bei dem die Master-Kalibriereinheit die Funktion hat, die optische Frequenz des Ausgangslichts der zu kalibrierenden Lichtquelle, die von der Slave-Kalibriereinheit über den optischen Übertragungsweg übertragen wurde, mittels der optischen Frequenzkammvorrichtung, die einen Offsetlaser umfasst, auf den die Frequenzstabilität des optischen Frequenzkamms durch eine Phasensynchronisation übertragen wurde, zu kalibrieren.

Ferner kann das Fernkalibriersystem des dritten Aspekts einen Aspekt (sechsten Aspekt) verwenden,

bei dem die Master-Kalibriereinheit die Funktion hat, die Dekodierung zum gleichzeitigen Kalibrieren der optischen Frequenz einer Mehrzahl von zu kalibrierenden Lichtquellen auszuführen.

Ferner kann das Fernkalibriersystem des fünften Aspekts einen Aspekt (siebten Aspekt) verwenden, bei dem die Master-Kalibriereinheit die Funktion hat, die Dekodierung zum gleichzeitigen Kalibrieren der optischen Frequenz einer Mehrzahl von zu kalibrierenden Lichtquellen auszuführen.

Die vorliegende Erfindung betrifft ferner ein Kalibrierverfahren, durch das eine optische Frequenz mindestens einer zu kalibrierenden Lichtquelle, die jeweils in mindestens einer Slave-Kalibriereinheit umfasst ist, mittels einer optischen Frequenzkammvorrichtung, mit der eine Master-Kalibriereinheit ausgestattet ist, die an einer von der Stelle, an der die zu kalibrierende Lichtquelle eingerichtet ist, entfernten Stelle eingerichtet ist, kalibriert wird,

wobei es sich um ein Verfahren für eine Fernkalibrierung einer optischen Frequenz handelt, bei dem die Slave-Kalibriereinheit und die Master-Kalibriereinheit durch eine optische Übertragungseinheit verbunden sind,

Ausgangslicht der zu kalibrierenden Lichtquelle, die in der Slave-Kalibriereinheit vorgesehen ist, über die optische Übertragungseinheit auf die Master-Kalibriereinheit übertragen wird,

und dafür gesorgt ist, dass durch die Master-Kalibriereinheit eine optische Frequenz des Ausgangslichts der zu kalibrierenden Lichtquelle der Slave-Kalibriereinheit, das über die optische Übertragungseinheit übertragen wurde, mittels einer elektrischen Ausgabe eines Schwebungssignals des Ausgangslichts der optischen Frequenzkammvorrichtung und des Ausgangslichts der zu kalibrierenden Lichtquelle beim Kalibrieren mittels der optischen Frequenzkammvorrichtung gemessen und kalibriert wird, und basierend auf einem auf der Basis von Zeit- und Frequenznormen fernkalibrierfähigen RF-Oszillator die Betriebsfrequenz der optischen Frequenzkammvorrichtung stabilisiert wird.

Ferner betrifft die vorliegende Erfindung ein Fernkalibriersystem für optische Frequenzen, das mindestens eine Slave-Kalibriereinheit, die mindestens eine zu korrigierende Lichtquelle und eine Messeinheit für optische Frequenzen umfasst, welche die optische Frequenz der zu kalibrierenden Lichtquelle misst,

eine Master-Kalibriereinheit, die an einer von der Stelle, an der die zu kalibrierende Lichtquelle eingerichtet ist, entfernten Stelle eingerichtet ist, eine optische Frequenzkammvorrichtung und eine Master-Kalibriereinheit umfasst, die eine Kalibriereinheit für optische Frequenzen umfasst, welche die optische Frequenz kalibriert,

und eine optische Übertragungseinheit umfasst, welche die Slave-Kalibriereinheit und die Master-Kalibriereinheit verbindet,

wobei die Master-Kalibriereinheit die Funktion hat, basierend auf einem auf der Basis von Zeit und Frequenznormen fernkalibrierfähigen RF-Oszillator die Betriebsfrequenz der optischen Frequenzkammvorrichtung zu stabilisieren und derart aufgebaut ist, dass sie das Ausgangslicht der optischen Frequenzkammvorrichtung über die optische Übertragungseinheit an die Slave-Kalibriereinheit überträgt,

wobei die Slave-Kalibriereinheit mittels der optischen Frequenz-Messeinheit basierend auf der elektrischen Ausgabe des Schwebungssignals des Ausgangslichts der zu kalibrierenden Lichtquelle, die in der Slave-Kalibriereinheit eingerichtet ist, und dem Ausgangslicht der optischen Frequenzkammvorrichtung, das an die Slave-Kalibriereinheit übertragen wurde, die optische Frequenz des Ausgangslichts der zu kalibrierenden Lichtquelle misst und das erhaltene RF-Frequenzsignal des Schwebungssignals über die optische Übertragungseinheit an die Master-Kalibriereinheit überträgt,

und wobei die Master-Kalibriereinheit außerdem derart aufgebaut ist, dass sie basierend auf dem RF-Frequenzsignal des Schwebungssignals, das von der Slave-Kalibriereinheit über die optische Übertragungseinheit übertragen wurde, durch die optische Frequenz-Kalibriereinheit die Frequenz des Ausgangslichts der zu kalibrierenden Lichtquelle kalibriert.

Ferner betrifft die vorliegende Erfindung ein Fernkalibriersystem für optische Frequenzen, das mindestens eine Slave-Kalibriereinheit, die mit mindestens einer zu kalibrierenden Lichtquelle ausgestattet ist,

eine Master-Kalibriereinheit, die an einer von der Stelle, an der die zu kalibrierende Lichtquelle eingerichtet ist, entfernten Stelle eingerichtet ist, eine optische Frequenzkammvorrichtung umfasst, und mittels der optischen Frequenzkammvorrichtung die optische Frequenz der zu kalibrierenden Lichtquelle, mit der die Slave-Kalibriereinheit ausgestattet ist, misst und kalibriert,

eine optische Übertragungseinheit, welche die Slave-Kalibriereinheit und die Master-Kalibriereinheit verbindet,

und eine Verwaltungseinheit mit der Funktion, einen Betriebszustand der Slave-Kalibriereinheit zu empfangen, der Funktion, einen Befehl zum Kalibrieren der zu kalibrierenden Lichtquelle an die Master-Kalibriereinheit zu senden, und der Funktion, ein Kalibrierergebnis von der Master-Kalibriereinheit zu empfangen, umfasst,

wobei die Slave-Kalibriereinheit die Funktion, den Betriebszustand an die Verwaltungseinheit zu senden, die Funktion, ein Umschaltsignal für einen optischen Pfad von der Master-Kalibriereinheit zu empfangen und die Funktion eines Verbindens mit dem Lichtleiter durch ein Umschalten des optischen Pfads des Ausgangslichts der zu kalibrierenden Lichtquelle hat,

und die Master-Kalibriereinheit die Funktion hat, wenn sie einen Kalibrierbefehl von der Verwaltungseinheit empfängt und einen Lichtweg-Umschaltbefehl an die Slave-Kalibriereinheit sendet und eine optische Frequenz des Ausgangslichts der zu kalibrierenden Lichtquelle, das von der Slave-Kalibriereinheit über den optischen Übertragungsweg übertragen wurde, mittels der optischen Frequenzkammvorrichtung kalibriert, die den Offsetlaser umfasst, an den die Frequenzstabilität des optischen Frequenzkamms durch Phasensynchronisation übertragen wurde, unter Verwendung einer elektrischen Ausgabe eines Schwebungssignals des Ausgangslichts der optischen Frequenzkammvorrichtung und des Ausgangslichts der zu kalibrierenden Lichtquelle, und einer elektrischen Ausgabe des Schwebungssignals des Ausgangslicht der optischen Frequenzkammvorrichtung und der Ausgabe eines Normallasers, dessen absolute Frequenz bekannt ist, die optische Frequenz zu messen und zu kalibrieren, die Funktion, ein Kalibrierergebnis an die Verwaltungseinheit zu senden, und außerdem die Funktion hat, über GPS basierend auf einem auf der Basis von Zeit und Frequenznormen fernkalibrierfähigen RF-Oszillator die Betriebsfrequenz der optischen Frequenzkammvorrichtung zu stabilisieren.

Ferner betrifft die vorliegende Erfindung ein Fernkalibriersystem für optische Frequenzen, das mindestens eine Slave-Kalibriereinheit, die mit mindestens einer zu kalibrierenden Lichtquelle ausgestattet ist,

eine Master-Kalibriereinheit, die an einer von der Stelle, an der die zu kalibrierende Lichtquelle eingerichtet ist, entfernten Stelle eingerichtet ist, eine optische Frequenzkammvorrichtung umfasst, und mittels der optischen Frequenzkammvorrichtung die optische Frequenz der zu kalibrierenden Lichtquelle, mit der die Slave-Kalibriereinheit ausgestattet ist, misst und kalibriert,
eine optische Übertragungseinheit, welche die Slave-Kalibriereinheit und die Master-Kalibriereinheit verbindet,
und eine Verwaltungseinheit mit der Funktion, einen Betriebszustand der Slave-Kalibriereinheit zu empfangen, der Funktion, einen Befehl zum Kalibrieren der zu kalibrierenden Lichtquelle an die Master-Kalibriereinheit zu senden, und der Funktion, ein Kalibrierergebnis von der Master-Kalibriereinheit zu empfangen, umfasst,
wobei die Slave-Kalibriereinheit die Funktion, den Betriebszustand an die Verwaltungseinheit zu senden, die Funktion, ein Umschaltsignal für einen Lichtweg von der Master-Kalibriereinheit zu empfangen, die Funktion eines Verbindens mit dem Lichtleiter durch ein Umschalten des Lichtwegs des Ausgangslichts der zu kalibrierenden Lichtquelle und eine Kodierfunktion hat, durch die bei der optischen Frequenz des Ausgangslichts der zu kalibrierenden Lichtquelle mittels eines optischen Modulators eine Frequenzmodulation erfolgt, und sich ständig die Modulationsfrequenz ändert, die für jede zu kalibrierende Lichtquelle verschieden ist,
und die Master-Kalibriereinheit die Funktion hat, wenn sie einen Kalibrierbefehl von der Verwaltungseinheit empfängt und einen Lichtweg-Umschaltbefehl an die Slave-Kalibriereinheit sendet, eine optische Frequenz des Ausgangslichts der zu kalibrierenden Lichtquelle, das von der Slave-Kalibriereinheit über den optischen Übertragungsweg übertragen wurde, mittels der optischen Frequenzkammvorrichtung, die mit dem Offsetlaser ausgestattet ist, an den die Frequenzstabilität des optischen Frequenzkamms durch Phasensynchronisation übertragen wurde, zu kalibrieren, die Funktion, beim Kalibrieren mittels einer elektrischen Ausgabe eines Schwebungssignals des Ausgangslichts der optischen Frequenzkammvorrichtung und des Ausgangslichts der zu kalibrierenden Lichtquelle und einer elektrischen Ausgabe des Schwebungssignals des Ausgangslicht der optischen Frequenzkammvorrichtung und der Ausgabe eines Normallasers, dessen absolute Frequenz bekannt ist, durch ein Mischen und Dekodieren der RF-Signale, die für die Kodierung des Ausgangslichts der zu kalibrierenden Lichtquellen verwendet wurden, wahlweise die optische Frequenz zu messen und kalibrieren, die Funktion, ein Kalibrierergebnis an die Verwaltungseinheit zu senden, und außerdem die Funktion hat, über GPS basierend auf einem auf der Basis von Zeit und Frequenznormen fernkalibrierfähigen RF-Oszillator die Betriebsfrequenz der optischen Frequenzkammvorrichtung zu stabilisieren.

Ferner betrifft die vorliegende Erfindung ein Fernkalibriersystem für optische Frequenzen, das mindestens eine Slave-Kalibriereinheit, die mit mindestens einer zu kalibrierenden Lichtquelle ausgestattet ist,

eine Master-Kalibriereinheit, die an einer von der Stelle, an der die zu kalibrierende Lichtquelle eingerichtet ist, entfernten Stelle eingerichtet ist, mit einer optischen Frequenzkammvorrichtung ausgestattet ist, und mittels der optischen Frequenzkammvorrichtung die optische Frequenz der zu kalibrierenden Lichtquelle, die von der Slave-Kalibriereinheit umfasst ist, misst und kalibriert,
eine optische Übertragungseinheit, welche die Slave-Kalibriereinheit und die Master-Kalibriereinheit verbindet,
und eine Verwaltungseinheit mit der Funktion, einen Betriebszustand der Slave-Kalibriereinheit zu empfangen, der Funktion, einen Befehl zum Kalibrieren der zu kalibrierenden Lichtquelle an die Master-Kalibriereinheit zu senden, und der Funktion, ein Kalibrierergebnis von der Master-Kalibriereinheit zu empfangen, umfasst,
wobei die Slave-Kalibriereinheit die Funktion, den Betriebszustand an die Verwaltungseinheit zu senden, die Funktion, ein Umschaltsignal für einen Lichtweg von der Master-Kalibriereinheit zu empfangen, die Funktion eines Verbindens mit dem Lichtleiter durch ein Umschalten des Lichtwegs des Ausgangslichts der zu kalibrierenden Lichtquelle und eine Kodierfunktion hat, durch die bei der optischen Frequenz des Ausgangslichts der zu kalibrierenden Lichtquelle mittels eines optischen Modulators eine Frequenzmodulation erfolgt, und sich ständig die Modulationsfrequenz ändert, die für jede zu kalibrierende Lichtquelle verschieden ist,
und die Master-Kalibriereinheit die Funktion hat, wenn sie einen Kalibrierbefehl von der Verwaltungseinheit empfängt und einen Lichtweg-Umschaltbefehl an die Slave-Kalibriereinheit sendet, eine optische Frequenz des Ausgangslichts der zu kalibrierenden Lichtquelle, das von der Slave-Kalibriereinheit über den optischen Übertragungsweg übertragen wurde, mittels der optischen Frequenzkammvorrichtung, die mit dem Offsetlaser ausgestattet ist, an den die Frequenzstabilität des optischen Frequenzkamms durch Phasensynchronisation übertragen wurde, zu kalibrieren, die Funktion, beim Kalibrieren mittels einer elektrischen Ausgabe eines Schwebungssignals des Ausgangslichts der optischen Frequenzkammvorrichtung und des Ausgangslichts der zu kalibrierenden Lichtquelle und einer elektrischen Ausgabe des Schwebungssignals des Ausgangslicht der optischen Frequenzkammvorrichtung und der Ausgabe eines Normallasers, dessen absolute Frequenz bekannt ist, durch ein Mischen und Dekodieren der RF-Signale, die für die Kodierung des Ausgangslichts der zu kalibrierenden Lichtquellen verwendet wurden, wahlweise die optische Frequenz zu messen und kalibrieren, die Funktion, zum gleichzeitigen Kalibrieren der optischen Frequenz einer Mehrzahl von zu kalibrierenden Lichtquellen die Dekodierung auszuführen, die Funktion, ein Kalibrierergebnis an die Verwaltungseinheit zu senden, und außerdem die Funktion hat, über GPS basierend auf einem auf der Basis von Zeit und Frequenznormen fernkalibrierfähigen RF-Oszillator die Betriebsfrequenz der optischen Frequenzkammvorrichtung zu stabilisieren.

**Effekte der Erfindung**

Dem Fernkalibriersystem gemäß der vorliegenden Erfindung zufolge kann eine zu kalibrierende Lichtquelle kalibriert werden, ohne die betreffende zu kalibrierende Lichtquelle aus der Anlage, in der die Slave-Kalibriereinheit vorgesehen ist, zu entnehmen. Beim Kalibrieren der zu kalibrierenden Lichtquelle ist ein nahtloser Übergang einer Anlage vom Betriebszustand zum Kalibrierzustand und vom Kalibrierzustand zum Betriebszustand möglich, wodurch das bisherige Problem der Ausfallzeit durch die Entnahme, den Transport, das Einsetzen und Aufwärmen der zu kalibrierenden Lichtquelle beseitigt und eine Maximierung der Produktivität einer Fabrik angestrebt werden kann. Da ferner der Kalibriervorgang durch eine Fernbedienung erfolgen kann, ist es möglich, eine Kalibriereinheit, von der eine präzise Messung verlangt wird, unbemannt vorzusehen und ihre Umgebung präzise auf eine ideale Temperatur zu regeln, sodass eine hochgradig stabile Umgebung mit wenigen aus der Bewegung einer Person resultierenden Schwingungen beibehalten werden kann.

Ferner kann die Anzahl der Slave-Kalibriereinheiten vergrößert werden, sodass bei einer Zunahme der Produktionsnachfrage die Anzahl der kalibrierbaren Lichtquellen erhöht werden kann. Ferner können dadurch, dass jeder zu kalibrierenden Lichtquelle ein unterschiedliches Modulations-/Demodulationssignal erteilt wird, eine Mehrzahl von zu kalibrierenden Lichtquellen gleichzeitig kalibriert werden, sodass ein skalierbares Kalibriersystem errichtet werden kann, das auch einer zukünftigen Vergrößerung der Anzahl der Lichtquellen entsprechen kann.

Da der Offsetlaser durch eine Phasenregelschleife auf die Phase des optischen Frequenzkamms ausgerichtet wird und außerdem eine hohe Kohärenz hat, kann er ferner als Teil der optischen Frequenzkammvorrichtung angesehen werden. Unter Ausnutzung der hohen optischen Ausgabe des Offsetlasers kann ein für die Messung der Schwebungsfrequenz wichtiges Signal-Rausch-Verhältnis von größer oder gleich 30 dB realisiert werden. Ferner können durch einen optischen Kodierungs- und elektrischen Dekodierungsmechanismus eine Vielzahl von zu kalibrierenden Lasern gleichzeitig kalibriert werden, ohne das schwache Ausgangslicht der optischen Frequenzkammvorrichtung aufzuteilen.

Werden ferner als zeit- und frequenzbezogene Normen nationale Normen verwendet, und die Betriebsfrequenz des optischen Frequenzkamms auf der Basis eines RF-Oszillators festgelegt, der mittels dieser Normen über einen GPS-Satelliten fernkalibriert wurde, kann ein auf die nationale Norm rückverfolgbarer Zustand geschaffen werden. Wird ferner die RF-Frequenz, die für das Kodieren und Dekodieren verwendet wird, durch eine Konstantenverdopplung des RF-Oszillators erzeugt, lassen sich ferner eine hervorragende langfristige Frequenzstabilität und ein Multiplexen von Schwebungssignalen miteinander vereinbaren.

Beim Kalibrieren der optischen Frequenz des Ausgangslichts der zu kalibrierenden Lichtquellen ist es ferner erforderlich, den Absolutwert der betreffenden optischen Frequenz zu messen. Zum Messen der Modenordnung der optischen Frequenz sind im Allgemeinen ein Verfahren mittels eines Wellenmessers und ein Verfahren, bei dem die Wiederholfrequenz der optischen Frequenzkammvorrichtung geändert wird, bekannt. Beim Verfahren mittels eines Wellenmessers führen jedoch eine Zunahme der Kosten und die Kürze des Kalibrierzyklus, die eine Verbesserung der Auflösung mit sich bringen, zu einem Engpass. Bei dem Verfahren, bei dem die Wiederhofrequenz geändert wird, handelt es sich ferner um eine komplizierte Messung unter Verwendung von zwei optischen Frequenzkammvorrichtungen, wobei bei der Handhabung von Abweichungen des Messergebnisses selbst Vorsicht unverzichtbar ist. Dadurch ergeben sich technische Schwierigkeiten bei der sicheren Spezifizierung der Modenordnung. Beim Fernkalibriersystem gemäß der vorliegenden Erfindung wird jedoch beim Kalibrieren der optischen Frequenz der zu kalibrierenden Lichtquelle das Ausgangslicht eines Normallasers verwendet, dessen absolute Frequenz bekannt ist. Die Modenordnung, die ein für die Messung der optischen Frequenz der zu kalibrierenden Lichtquelle erforderlicher Parameter ist, wird mit der absoluten Frequenz des Normallasers als Referenzwert ermittelt. Dadurch kann eine Kalibrierung der optischen Frequenz einer zu kalibrierenden Lichtquelle präzise durchgeführt werden.

## Kurze Erläuterung der Zeichnungen

[Fig. 1] Fig. 1 ist ein Blockbild, das den schematischen Aufbau eines Kalibriersystems vom Streuungstyp gemäß einer ersten Ausführungsform der vorliegenden Erfindung zeigt.

[Fig. 2] Fig. 2 ist ein Blockbild, das den schematischen Aufbau einer Slave-Kalibrierkammer gemäß der vorliegenden Ausführungsform zeigt.

[Fig. 3] Fig. 3 ist ein Blockbild, das den schematischen Aufbau einer Master-Kalibrierkammer gemäß der vorliegenden Ausführungsform zeigt.

[Fig. 4] Fig. 4 ist ein Blockbild, das den schematischen Aufbau einer Master-Kalibrierkammer gemäß einer Abwandlung zeigt.

[Fig. 5] Fig. 5 ist ein Blockbild, das den schematischen Aufbau einer Lichtfrequenz-Messeinheit gemäß der vorliegenden Ausführungsform zeigt.

[Fig. 6] Fig. 6 ist ein Blockbild, das den schematischen Aufbau einer Lichtfrequenz-Messeinheit gemäß einer Abwandlung zeigt.

[Fig. 7] Fig. 7 ist eine erläuternde Ansicht zur Erläuterung des Lichtfrequenz-Messverfahrens gemäß der vorliegenden Ausführungsform.

[Fig. 8] Fig. 8 ist ein Blockbild, das den schematischen Aufbau einer Slave-Kalibrierkammer gemäß einer weiteren Ausführungsform der vorliegenden Erfindung zeigt.

[Fig. 9] Fig. 9 ist ein Blockbild, das den schematischen Aufbau einer Lichtfrequenz-Messeinheit gemäß der weiteren Ausführungsform der vorliegenden Erfindung zeigt.

[Fig. 10] Fig. 10 ist eine Ansicht bezüglich eines konkreten Strukturbeispiels einer Lichtweg-Umschaltvorrichtung/Multiplexereinheit der Slave-Kalibrierkammer gemäß der vorliegenden Erfindung.

[Fig. 11] Fig. 11 ist eine Ansicht bezüglich eines konkreten Strukturbeispiels einer photo-elektrischen Konversionseinheit bei einer Master-Lichtweg-Umschaltvorrichtung/Frequenzmesseinheit der Master-Kalibrierkammer gemäß der vorliegenden Erfindung.

[Fig. 12] Fig. 12 sind schematische Ansichten von zwei Strukturen der Frequenz-Messeinheit bei der vorliegenden Erfindung.

[Fig. 13] Fig. 13 ist ein Strukturbeispiel der Master-Kalibrierkammer beim Messsystem 2 in Fig. 12.

[Fig. 14] Fig. 14 ist ein Strukturbeispiel der Master-Kalibrierkammer beim Messsystem 2 in Fig. 12.

[Fig. 15] Fig. 15 ist ein Blockbild, das den schematischen Aufbau einer Lichtfrequenz-Messeinheit gemäß einer Abwandlung zeigt.

[Fig. 16] Fig. 16 ist ein Blockbild, das den schematischen Aufbau einer Lichtfrequenz-Messeinheit gemäß einer Abwandlung zeigt.

[Fig. 17] Fig. 17 ist ein Blockbild, das den schematischen Aufbau einer Lichtfrequenz-Messeinheit gemäß einer Abwandlung zeigt.

## Formen zur Ausführung der Erfindung

Im Folgenden werden konkrete Formen zur Ausführung der vorliegenden Erfindung basierend auf den Zeichnungen erläutert.

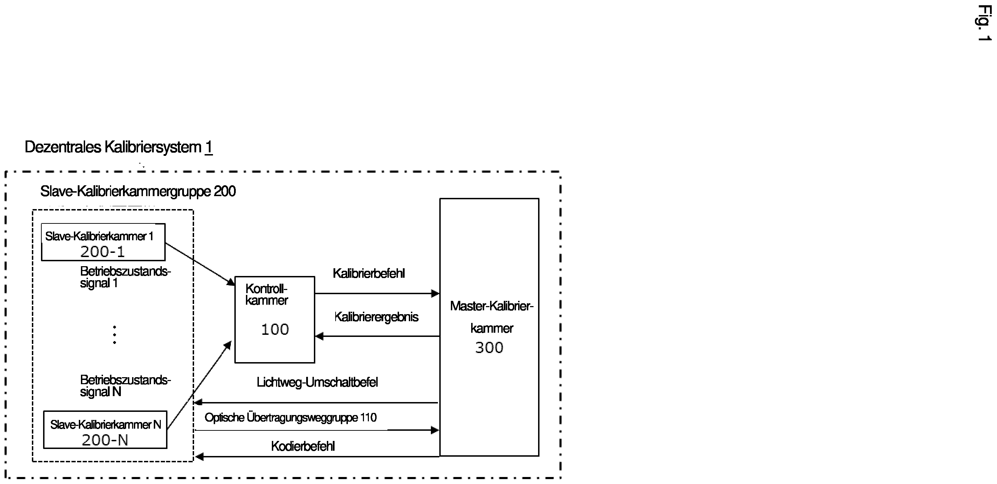

Fig. 1 ist ein Blockbild, das den schematischen Aufbau eines dezentralen Kalibriersystems (1) gemäß der vorliegenden Ausführungsform zeigt. Im Folgenden wird das dezentrale Kalibriersystem (1) des vorliegenden Beispiels erläutert.

1. Aufbau des dezentralen Kalibriersystems

Wie in Fig. 1 gezeigt, umfasst das dezentrale Kalibriersystem (1) des vorliegenden Beispiels eine Verwaltungskammer (Verwaltungseinheit) (100), eine Master-Kalibrierkammer (Master-Kalibriereinheit) (300), die mit einer optischen Frequenzkammvorrichtung ausgestattet ist, und eine Slave-Kalibrierkammer(Slave-Kalibriereinheit)-Gruppe (200), die mit zu kalibrierenden Lichtquellen ausgestattet ist. Die Slave-Kalibrierkammer-Gruppe (200) wird aus N-Stück dezentral angeordneten Slave-Kalibrierkammern 1 (200-1) bis N (200-N) gebildet. In den jeweiligen Slave-Kalibrierkammern ist mindestens eine zu kalibrierende Lichtquelle vorgesehen. Hierbei ist N eine die Anzahl der Slave-Kalibrierkammern ausdrückende natürliche Zahl einschließlich 1.

Beim Kalibrieren übertragen zunächst Slave-Kalibrierkammer 1 (200-1) ein Betriebszustandssignal 1, ... Slave-Kalibrierkammer N (200-N) ein Betriebszustandssignal N der Anlage an die Verwaltungskammer (100), und basierend auf diesen Betriebszuständen beurteilt die Verwaltungskammer (100), bei welcher zu kalibrierenden Lichtquelle in welcher Slave-Kalibrierkammer eine Kalibrierung möglich (oder erforderlich) ist, und übermittelt einen Kalibrierbefehl an die Master-Kalibrierkammer (300).

Die Master-Kalibrierkammer (300), die den Kalibrierbefehl empfangen hat, sendet einen den jeweiligen Lichtweg der zu kalibrierenden Lichtquellen der Slave-Kalibrierkammer-Gruppe (200) umschaltenden Lichtweg-Umschaltbefehl, sodass das Ausgangslicht von einer oder mehr zu kalibrierenden Lichtquellen, als Gegenstand des Kalibrierbefehls, die in einer Slave-Kalibrierkammer eingerichtet sind, an die Master-Kalibrierkammer (300) übertragen wird. Gleichzeitig sendet sie einen Befehl zum Modulieren und Multiplexen der optischen Frequenz der zu kalibrierenden Lichtquelle.

Die Slave-Kalibrierkammer einschließlich der zu kalibrierenden Lichtquellen als Gegenstand des Kalibrierbefehls empfängt den Lichtweg-Umschaltbefehl und den Kodierbefehl, schaltet den Lichtweg des Ausgangslichts der zu kalibrierenden Lichtquellen, die in der betreffenden Slave-Kalibrierkammer eingerichtet sind, um und erteilt der optischen Frequenz für jede zu kalibrierende Lichtquelle ein unterschiedliches Modulationsmuster, sorgt dafür, dass sich das Ausgangslicht der zu kalibrierenden Lichtquelle im betreffenden optischen Übertragungsweg einer optischen Übertragungsweggruppe (110) ausbreitet und sendet es zur Master-Kalibrierkammer (300). Hierbei werden als optischer Übertragungsweg anstelle eines freien Ausbreitungsraums Beispiele eines Übertragungswegs mittels optischer Fasern oder eines Lichtleiters angeführt.

Nach dem Senden des Ausgangslichts der zu kalibrierenden Lichtquelle an die Master-Kalibrierkammer (300), erfolgen bei der Master-Kalibrierkammer (300) mittels des eingerichteten optischen Frequenzkamms eine Dekodierung und ein Kalibrieren der optischen Frequenz des Ausgangslichts einer oder einer Mehrzahl von zu kalibrierenden Lichtquellen, Mitteilung des Kalibrierergebnisses an die Verwaltungskammer (100) und Übertragung eines Lichtwegumschaltung-Befehlssignals an die Slave-Kalibriergruppe (200), wobei mit der Durchführung der Lichtwegumschaltung, bei welcher der Lichtweg des Ausgangslichts der zu kalibrierenden Lichtquellen, deren Kalibrierung abgeschlossen ist, in eine Vorrichtung in der betreffenden Slave-Kalibrierkammer aufgenommen wird, das Kalibrieren der dem Kalibrierbefehl entsprechenden zu kalibrierenden Lichtquelle endet.

Die Verwaltungskammer (100) empfängt das Kalibrierergebnis und legt einen Zeitplan für das nächste Kalibrieren fest. Nachdem das Kalibrieren zu Ende ist, führt die Master-Kalibrierkammer (300), die von der Verwaltungskammer (100) einen neuen Kalibrierbefehl empfangen hat, die vorstehende Reihe von Abläufen für die zu kalibrierende Lichtquelle der dem neuen Kalibrierbefehl entsprechenden Slave-Kalibrierkammer aus.

Durch einen Kalibrierbefehl können eine Mehrzahl von Slave-Kalibrierkammern ausgewählt werden. Ferner können durch einen Kalibrierbefehl eine Mehrzahl von zu kalibrierenden Lichtquellen gleichzeitig kalibriert werden.

2. Aufbau der Slave-Kalibrierkammer

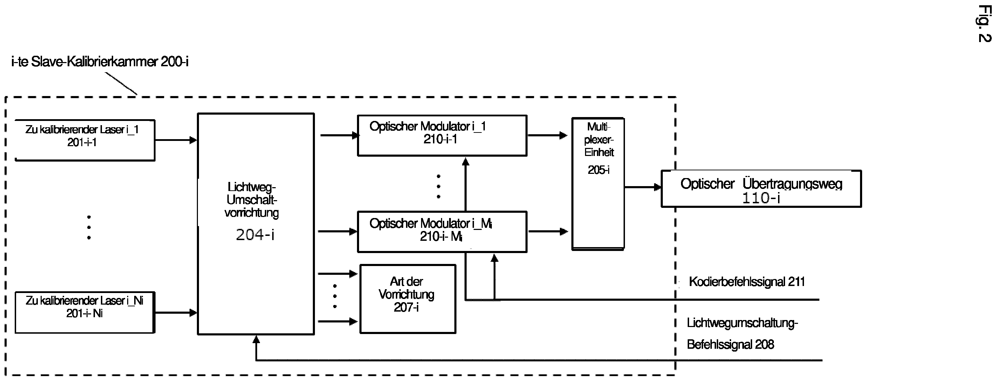

Fig. 2 ist ein Blockbild, das von der Slave-Kalibrierkammergruppe (200) den schematischen Aufbau einer i-ten Slave-Kalibrierkammer (200-i) zeigt. Hierbei ist i eine beliebige natürliche Zahl von 1 bis N. Die i-te Slave-Laserkammer (200-i) hat $N_i$-Stück zu kalibrierende Laser, die jeweils als zu kalibrierender Laser $i\_N_i$ (201-i-$N_i$), ..., zu kalibrierender Laser $i\_N_i$ (201-i-$N_i$) gekennzeichnet sind. N ist eine natürliche Zahl einschließlich ($N_i$ = 1) für den Fall, dass es sich nur um einen zu kalibrierenden Laser handelt.

Erfolgt nicht die Kalibrierung sämtlicher zu kalibrierenden Laser in der i-ten Slave-Kalibrierkammer (200-i), werden die zu kalibrierenden Laser bei einer Vorrichtungsgattung (207-i) verwendet, wurden jedoch von der Master-Kalibrierkammer (300) ein Lichtwegumschaltung-Befehlssignal (208) und Kodier-Befehlssignal (211) gesendet, schaltet eine Lichtweg-Umschaltvorrichtung (204-i) den Lichtweg des betreffenden zu kalibrierenden Lasers auf eine Übertragung an eine Multiplexereinheit (205-i) und einen optischen Übertragungsweg (110-i) um. Fig. 2 umfasst dabei auch den Fall, dass eine Slave-Kalibrierkammer nur einen zu kalibrierenden Laser hat, oder nur ein Laser kalibriert wird.

Bevor eine zu kalibrierende Lichtquelle als Objekt des Kalibrierens mit dem optischen Übertragungsweg (110-i) verbunden wird, erfolgt außerdem eine Modulation durch einen im Lichtweg des zu kalibrierenden Lasers als Objekt des Kalibrierens vorgesehenen optischen Modulator von einem der optischen Modulatoren $i\_1$ (210-i-1) bis $i\_M_i$ (210-i$M_i$). Hierbei ist $M_i$ die maximale Anzahl der von der i-ten Slave-Kalibrierkammer (200-i) übertragbaren zu kalibrierenden Lichtquellen und eine natürliche Zahl größer oder gleich 1 und kleiner oder gleich $N_i$. Basierend auf dem Modulationsmuster eines Kodierbefehlssignal (211) führt der betreffende optische Modulator mit jeweils unterschiedlichen Mustern eine Frequenzmodulation der Phase oder Frequenz des Ausgangslichts einer Mehrzahl von zu kalibrierenden Lichtquellen durch.

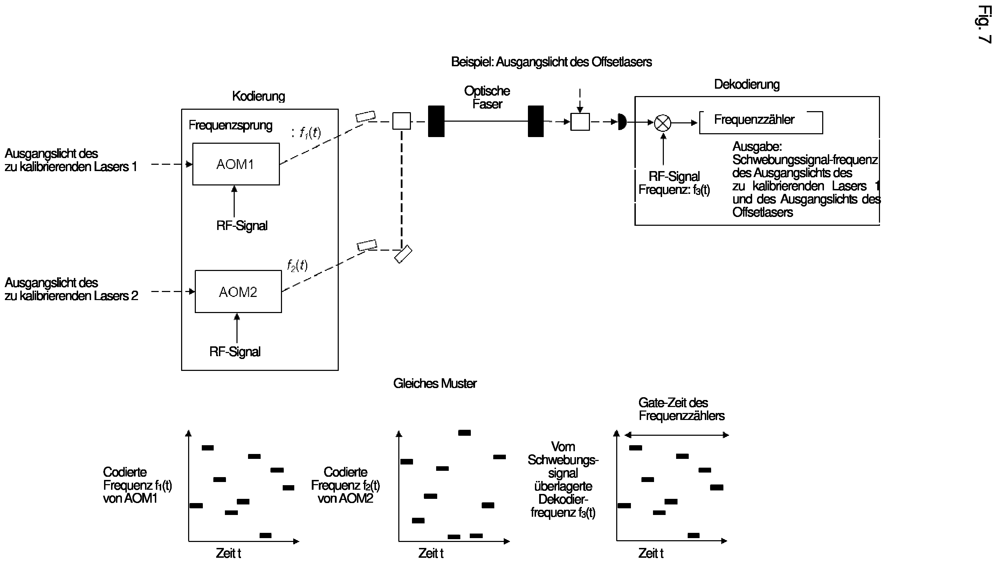

Beispielsweise ist es vorstellbar, dass bei einem akustooptischen Modulator (AOM) als Beispiel für einen eine Frequenz modulierenden optischem Modulator ein RF-Signal, das durch ein Anlegen an den AOM das Ausgangslicht einer zu kalibrierenden Lichtquelle diffraktiert und außerdem deren Ausgangsfrequenz verschiebt, durch ein sequentielles Springen während des Kalibrierens kodiert wird, durch eine elektrische Teilung in der Master-Kalibrierkammer ein Schwebungssignal eine im Folgenden beschriebene Dekodierung erfolgt, und das Kalibrieren der optischen Frequenz einer Mehrzahl von zu kalibrierenden Lichtquellen gleichzeitig durchgeführt wird (Fig. 7 zeigt ein detailliertes Beispiel).

3. Aufbau der Master-Kalibrierkammer

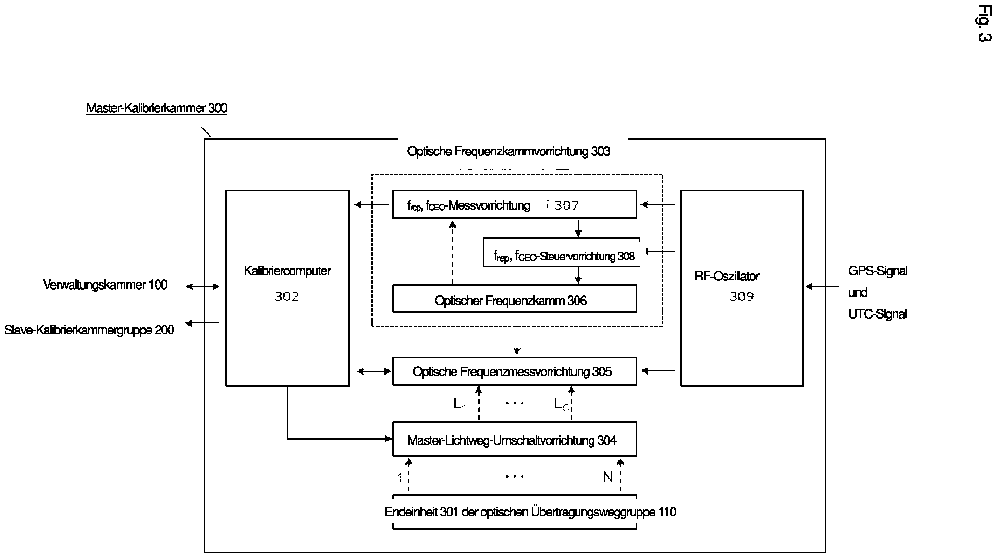

Fig. 3 ist ein Blockbild, das den schematischen Aufbau einer Master-Kalibrierkammer gemäß dem vorliegenden Beispiel zeigt. Durchgezogene Pfeile zeigen ein elektrisches Signal und gestrichelte Pfeile zeigen ein optisches Signal. Die Master-Kalibrierkammer (300) hat eine Endeinheit (301) einer aus N-Stück optischen Übertragungswegen bestehenden optischen Übertragungsweggruppe (110). Empfängt ein Kalibriercomputer (302) einen Kalibrierbefehl von der Verwaltungskammer (100), gibt er an die betreffenden zu kalibrierenden Lichtquellen aus der Slave-Kalibrierkammergruppe (200) eine Lichtwegumschaltung-Befehlsgruppe aus, wodurch von C-Stück optischen Ausgangsanschlüssen aus N-Stück optischen Ausgangsanschlüssen, welche die Endeinheit (301) der optischen Übertragungsweggruppe (110) bilden, Licht der jeweiligen zu kalibrierenden Lichtquellen ausgestrahlt wird. Die Stückzahl D der Lichtquellen, die durch eine optische Frequenzkammvorrichtung (303) gleichzeitig kalibriert werden können, ist C oder größer als C.

Damit aus den N-Stück optischen Ausgangsanschlüssen der Anschluss, aus dem tatsächlich Licht austritt, das Schwebungssignal mit einer optischen Frequenzkammvorrichtung (303) aufnimmt, schaltet der Kalibriercomputer (302) den Lichtweg einer Master-Lichtweg-Umschaltvorrichtung (304) um, sodass aus den Ausgangslichtwegen der Master-Lichtweg-Umschaltvorrichtung (304) auf C-Stück Lichtwege $L_1$, ..., $L_C$ (in einen Lichtweg kann das Ausgangslicht einer Mehrzahl von zu kalibrierenden Lichtquellen eintreten) Ausgangslicht der zu kalibrierenden Lichtquellen verteilt wird und in eine Optische-Frequenz-Messvorrichtung (305) eintritt.

Die optische Frequenzkammvorrichtung (303) umfasst einen optischen Frequenzkamm (306), eine $f_{rep}$, $f_{CEO}$-Messvorrichtung (307), die basierend auf der optischen Ausgabe des optischen Frequenzkamms (306) eine Wiederholfrequenz $f_{rep}$ und eine CEO-Frequenz $f_{CEO}$ misst, und eine $f_{rep}$, $f_{CEO}$-Steuervorrichtung (308), die eine Rückkopplung an den optischen Frequenzkamm (306) durchführt, um die von der $f_{rep}$, $f_{CEO}$-Messvorrichtung (307) ausgegebenen $f_{rep}$, $f_{CEO}$ zu stabilisieren, und gibt $f_{rep}$, $f_{CEO}$-Signale an den Kalibriercomputer (302) aus.

Als Beispiel für den Aufbau des optischen Frequenzkamms (306) ist ein solcher aus einem Oszillator in Form eines Er- oder Yb-dotierten Faserlasers oder Titan-Saphier-Lasers, einem Verstärkungsmechanismus wie einem EDFA, der einen Teil der optischen Ausgabe abzweigt und anschließend verstärkt, einer nicht-linearen Faser zur Vergrößerung des Wellenlängenbereichs nach der Verstärkung, einem optischen System/Messsystem, bei dem dadurch, dass die optische Leistung einer nicht-linearen Faser in einen nicht-linearen optischen Kristall wie einen Periodically Poled Lithium Niobate (PPLN, Periodisch gepolter Lithiumniobatkristall) eingegeben und sekundäre Harmonische erzeugt werden, die CEO-Frequenz gemessen wird, und einem optischen System/Photodetektor, das/der die Wiederholfrequenz misst, oder einem Verstärkungsmechanismus wie einem EDFA, der die optische Ausgabe des Oszillators für die Kalibrierung abzweigt und anschließend verstärkt, einer nicht-linearen Faser, welche den Wellenlängenbereich für die Kalibrierung vergrößert, einer Struktur wie einem Beugungsgitter oder einem Bandpassfilter, durch die aus der Ausgabe der linearen Faser andere als die Wellenlänge fürs Kalibrieren ausgeschlossen werden, und eines optischen Systems für eine dezentrale Korrektur von Impulsen denkbar.

Der Kalibriercomputer (302) gibt einen Befehl aus, durch den an die Optische-Frequenz-Messvorrichtung (305) ein im Folgenden beschriebenes Dekodiersignal erteilt wird, empfängt Informationen einer Schwebungsfrequenz $f_{beat}$ und einer Modenordnung n, die von der Optische-Frequenz-Messvorrichtung (305) ausgegeben werden, und Informationen der Wiederhofrequenz $f_{rep}$ und der CEO-Frequenz $f_{CEO}$ von der $f_{rep}$, $f_{CEO}$-Messvorrichtung (307) und legt die optische Frequenz der zu kalibrierenden Lichtquellen nach der folgenden Gleichung 1 fest.

(Gleichung 1)

$$f = n \times f_{rep} \pm \mid f_{CEO} \mid \pm \mid f_{beat} \mid$$

Zur Festlegung des jeweiligen Codes für $f_{CEO}$ und $f_{beat}$ von Gleichung 1 wird z. B. ein Verfahren verwendet, bei dem die Festlegung anhand der Verschiebungsrichtung der Schwebungsfrequenz und CEO-Frequenz bei einer Änderung von $f_{rep}$ erfolgt. Je nach Lichtquelle kann es zwar auch zu einem Frequenzdrift kommen, der $f_{rep}$ übersteigt, da dies aber meistens infolge eines Aufwärmens passiert, ist eine Umgehung durch Maßnahmen wie eine Überwachung von Informationen über Temperatur, Luftfeuchte und Luftdruck der Einstellungsumgebung, Durchführung einer Abnormalitätserkennung durch die Implementierung einer Alarmfunktion und Änderung des Kalibrierzeitpunkts möglich.

Die Stabilität der optischen Frequenzmessung unter Verwendung der vorstehenden optischen Frequenzkammvorrichtung (303) wird durch die Frequenzstabilität der $f_{rep}$, $f_{CEO}$-Messvorrichtung (307), der $f_{rep}$, $f_{CEO}$-Steuervorrichtung (308) und eines RF-Oszillators (309), der ein RF-Frequenz-Referenzsignal mittels einer Messung/Steuerung durch die Optische-Frequenz-Messvorrichtung (305) erzeugt, festgelegt, wobei z. B. ein Rubidium-Oszillator oder dessen GPS-synchronisierter Oszillator (GPSDO, GPS-disciplined Oscillator) verwendet wird. Da beim vorliegenden Beispiel ein Fernkalibrieren des RF-Oszillators (309) mit nationalen Zeit-/Frequenznormen und über GPS-Satelliten erfolgt, werden ein GPS-Signal und ein UTC-Signal über das Internet zur Stabilisierung der Oszillationsfrequenz des RF-Oszillators (309) verwendet. Ein Fernkalibrieren kann durch die Nutzung eines Services mittels GPS Common View ausgeführt werden.

Die vorstehende optische Frequenzmessung erfolgt für C-Stück der zu kalibrierenden Lichtquellen, die dem Kalibrierbefehl entsprechen. Dadurch können eine Mehrzahl von zu kalibrierenden Lichtquellen durch die optische Frequenzkammvorrichtung kalibriert werden, ohne sie aus der Slave-Kalibrierkammer herauszubewegen.

4. Abwandlung der Master-Kalibrierkammer

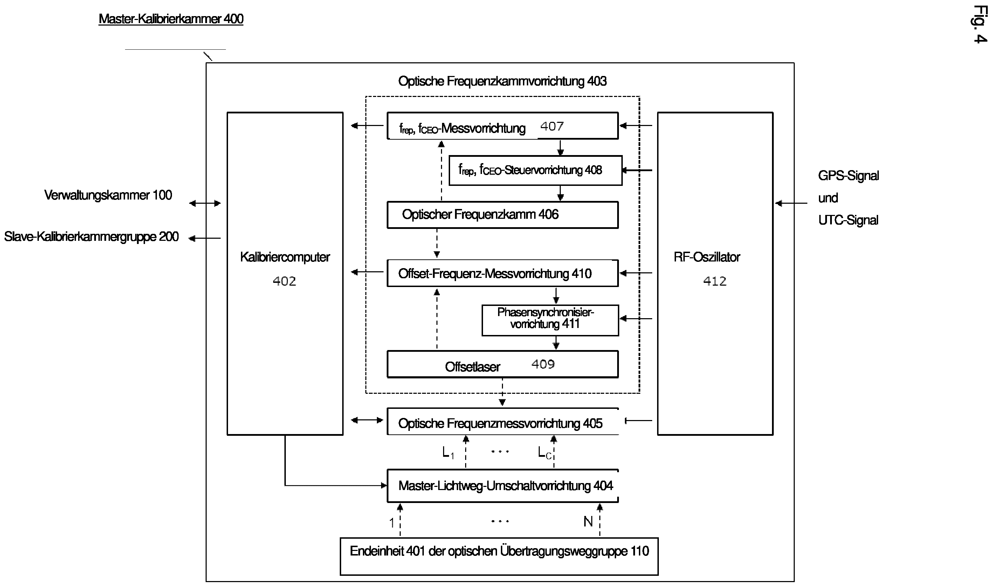

Fig. 4 ist ein Blockbild, das den schematischen Aufbau einer Master-Kalibrierkammer gemäß einer Abwandlung zeigt. Bei der vorliegenden Erfindung kann für die Master-Kalibrierkammer anstelle der vorstehend beschriebenen Master-Kalibrierkammer (300) der in Fig. 4 gezeigte Aspekt verwendet werden. In Fig. 4 zeigen durchgezogene Pfeile ein elektrisches Signal und gestrichelte Pfeile ein optisches Signal. Die Master-Kalibrierkammer (400) hat eine Endeinheit (401) einer aus N-Stück optischen Übertragungswegen bestehenden optischen Übertragungsweggruppe (110). Empfängt ein Kalibriercomputer (402) einen Kalibrierbefehl von der Verwaltungskammer (100), gibt er an die betreffenden zu kalibrierenden Lichtquellen aus der Slave-Kalibrierkammergruppe (200) eine Lichtwegumschaltung-Befehlsgruppe aus, wodurch von C-Stück optischen Ausgangsanschlüssen aus N-Stück optischen Ausgangsanschlüssen, welche die Endeinheit (401) der optischen Übertragungsweggruppe (110) bilden, Licht der jeweiligen zu kalibrierenden Lichtquellen ausgestrahlt wird. Die Stückzahl D der Lichtquellen, die durch eine optische Frequenzkammvorrichtung (403) gleichzeitig kalibriert werden können, ist C oder größer als C.

Damit aus den N-Stück optischen Ausgangsanschlüssen der Anschluss, aus dem tatsächlich Licht austritt, das Schwebungssignal mit einer optischen Frequenzkammvorrichtung (403) aufnimmt, schaltet der Kalibriercomputer (402) den Lichtweg einer Master-Lichtweg-Umschaltvorrichtung (404) um, sodass aus den Ausgangslichtwegen der Master-Lichtweg-Umschaltvorrichtung (404) auf C-Stück Lichtwege $L_1$, ..., $L_C$ (in einen Lichtweg kann das Ausgangslicht einer Mehrzahl von zu kalibrierenden Lichtquellen eintreten) Ausgangslicht der zu kalibrierenden Lichtquellen jeweils verteilt wird und in eine Optische-Frequenz-Messvorrichtung (405) eintritt.

Die optische Frequenzkammvorrichtung (403) umfasst einen optischen Frequenzkamm (406), eine $f_{rep}$, $f_{CEO}$-Messvorrichtung (407), die basierend auf der optischen Ausgabe des optischen Frequenzkamms (406) eine Wiederholfrequenz $f_{rep}$, eine CEO-Frequenz $f_{CEO}$ misst, und eine $f_{rep}$, $f_{CEO}$-Steuervorrichtung (408), die eine Rückkopplung an den optischen Frequenzkamm (406) durchführt, um die von der $f_{rep}$, $f_{CEO}$-Messvorrichtung (407) ausgegebenen $f_{rep}$, $f_{CEO}$ zu stabilisieren, einen Offsetlaser (409), eine Offset-Frequenz-Messvorrichtung (410), welche eine Offset-Frequenz $f_{offset}$ für den optischen Frequenzkamm des Offsetlasers misst, und eine Phasensynchronisiervorrichtung (411) zum vollständigen Synchronisieren der Offsetfrequenz für den optischen Frequenzkamm und gibt $f_{rep}$, $f_{CEO}$, $f_{offset}$-Signale an den Kalibriercomputer (402) aus.

Als Beispiel für den Aufbau des optischen Frequenzkamms (406) kann ein solcher aus einem Oszillator in Form eines Er- oder Yb-dotierten Faserlasers oder Titan-Saphier-Lasers, einem Verstärkungsmechanismus wie einem EDFA, der einen Teil der optischen Ausgabe abzweigt und anschließend verstärkt, einer nichtlinearen Faser zur Vergrößerung des Wellenlängenbereichs nach der Verstärkung, einem optischen System/-Messsystem, bei dem dadurch, dass die optische Leistung einer nicht-linearen Faser in einen nicht-linearen optischen Kristall wie einen Periodically Poled Lithium Niobate (PPLN, Periodisch gepolter Lithiumniobatkristall) eingegeben und sekundäre Harmonische erzeugt werden, die CEO-Frequenz gemessen wird, und einem Photodetektor, der die Wiederholfrequenz misst, oder einem Verstärkungsmechanismus wie einem EDFA, der die optische Ausgabe des Oszillators für die Kalibrierung abzweigt und anschließend verstärkt, einer nichtlinearen Faser, welche den Wellenlängenbereich für die Kalibrierung vergrößert, und einer Struktur wie einem Beugungsgitter oder einem Bandpassfilter, durch die aus der Ausgabe der linearen Faser eine andere als die Wellenlänge für die Kalibrierung ausgeschlossen werden, angeführt werden.

Als Nächstes ist als Strukturbeispiel für den Offsetlaser (409) ein Aufbau bekannt, bei dem eine Rückkopplung zu einem piezoelektrischen Element, durch das ein Resonator eines externen Resonator-Halbleiterlasers angetrieben wird, und dem Antriebsstrom einer Laserdiode erfolgt, und eine laterale Ein-Modenoszillation realisiert wird. Hinsichtlich der Frequenzstabilität des Offsetlasers (409) kann durch ein kombiniertes slow feedback aufgrund des piezoelektrischen Elements, welches den externen Resonator moduliert, und fast feedback aufgrund des Antriebsstroms der Laserdiode als Rückkopplungsmechanismus mittels einer Phasensynchronisiervorrichtung (411) (wie z. B. eine digitalen PLL-Schaltung) die Phase des Offsetlasers (409) und des optischen Frequenzkamms (406) über einen Breitbandbereich von einigen Dutzend Mhz gesichert werden. Das heißt, da die Frequenzstabilität des optischen Frequenzkamms (406) auf den Offsetlaser (409) übertragen werden kann, ist der Offsetlaser (409) in der optischen Frequenzkammvorrichtung enthalten. Die Phasensynchronisiervorrichtung (411) hat die Funktion, mittels eines Messmittels wie einem Wellenmesser die Resonatorlänge des Offsetlasers (409) derart zu steuern, dass die Differenz zwischen der Oszillationsfrequenz des zu kalibrierenden Lasers und der Oszillationsfrequenz des Offsetlasers (409) kürzer als die Wiederholfrequenz der optischen Frequenzkammvorrichtung wird, bevor der Offsetlaser (409) bezüglich des optischen Frequenzkamms (406) gesichert wird. Als anderes Messmittel abgesehen von einem Wellenmesser kann ein Messmittel angeführt werden, durch das der Offsetlaser (409) mit einem Laser (z. B. einem jodstabilisierten Helium-Neonlaser, einem acetylenstabilisierten Helium-Neon-Laser, eine optischen Gitteruhr usw.), bei dem die Unklarheit der absoluten Frequenz kleiner als der Modenabstand des optischen Frequenzkamms ist, optisch interferiert und deren Schwebungssignal ermittelt wird.

Der Kalibriercomputer (402) gibt einen Befehl aus, durch den an die Optische-Frequenz-Messvorrichtung (405) ein im Folgenden beschriebenes Dekodiersignal erteilt wird, empfängt Informationen einer Schwebungsfrequenz $f_{beat}$ und einer Modenordnung n des Offsetlasers und der zu kalibrierenden Lichtquelle, die von der Optische-Frequenz-Messvorrichtung (405) ausgegeben werden, Informationen der Wiederhofrequenz $f_{rep}$ und der CEO-Frequenz $f_{CEO}$ von einer $f_{rep}$, $f_{CEO}$-Messvorrichtung (407) und Informationen der Schwebungsfrequenz $f_{offset}$ des optischen Frequenzkamms (406) und des Offsetlasers (409) von der Offsetfrequenz-Messvorrichtung 410, und legt die optische Frequenz nach der folgenden Gleichung 2 fest.

(Gleichung 2)

$$F = n \times f_{rep} \pm | f_{CEO} | \pm | f_{Offset} | \pm | f_{beat} |$$

Zur Festlegung des jeweiligen Codes für $f_{CEO}$, $f_{offset}$ und $f_{beat}$ von Gleichung 2 wird z. B. ein Verfahren verwendet, bei dem die Festlegung anhand der Verschiebungsrichtung von $f_{offset}$ und $f_{CEO}$ bei einer Änderung von $f_{rep}$ erfolgt. Je nach Lichtquelle kann es zwar auch zu einem Frequenzdrift kommen, der $f_{rep}$ übersteigt, da dies aber meistens infolge eines Aufwärmens passiert, ist eine Umgehung durch Maßnahmen wie eine Überwachung von Informationen über Temperatur, Luftfeuchte und Luftdruck der Einstellungsumgebung, Durchführung einer Abnormalitätserkennung durch die Implementierung einer Alarmfunktion und Änderung des Kalibrierzeitpunkts möglich.

Die Stabilität der optischen Frequenzmessung unter Verwendung der vorstehenden optischen Frequenzkammvorrichtung (403) wird durch die Frequenzstabilität eines RF-Resonators (412) als Grundlage für die Bildung der RF-Frequenz, die für die Messung/Steuerung durch die $f_{rep}$, $f_{CEO}$-Messvorrichtung (407), die $f_{rep}$, $f_{CEO}$-Steuervorrichtung (408), die Offsetfrequenz-Messvorrichtung (410), die Phasensynchronisiervorrichtung (411) und die optische Frequenzmessvorrichtung (405) verwendet wird, festgelegt, wobei z. B. ein Rubidium-Oszillator oder dessen GPS-synchronisierter Oszillator (GPSDO, GPS-disciplined Oscillator) verwendet wird. Da bei der vorliegenden Erfindung ein Fernkalibrieren des RF-Oszillators (412) mit nationalen Zeit-/Frequenznormen (Beispiel einer Norm) und über GPS-Satelliten erfolgt, werden ein GPS-Signal und ein UTC-Signal über das Internet zur Stabilisierung des RF-Oszillators (412) verwendet. Eine Fernkalibrierung kann durch die Nutzung eines Services mittels GPS Common View ausgeführt werden.

Die vorstehende optische Frequenzmessung erfolgt für C-Stück der zu kalibrierenden Lichtquellen, die dem Kalibrierbefehl entsprechen. Dadurch können eine Mehrzahl von zu kalibrierenden Lichtquellen durch die optische Frequenzkammvorrichtung kalibriert werden, ohne sie aus der Slave-Kalibrierkammer herauszubewegen.

5. Aufbau der Lichtfrequenz-Messeinheit

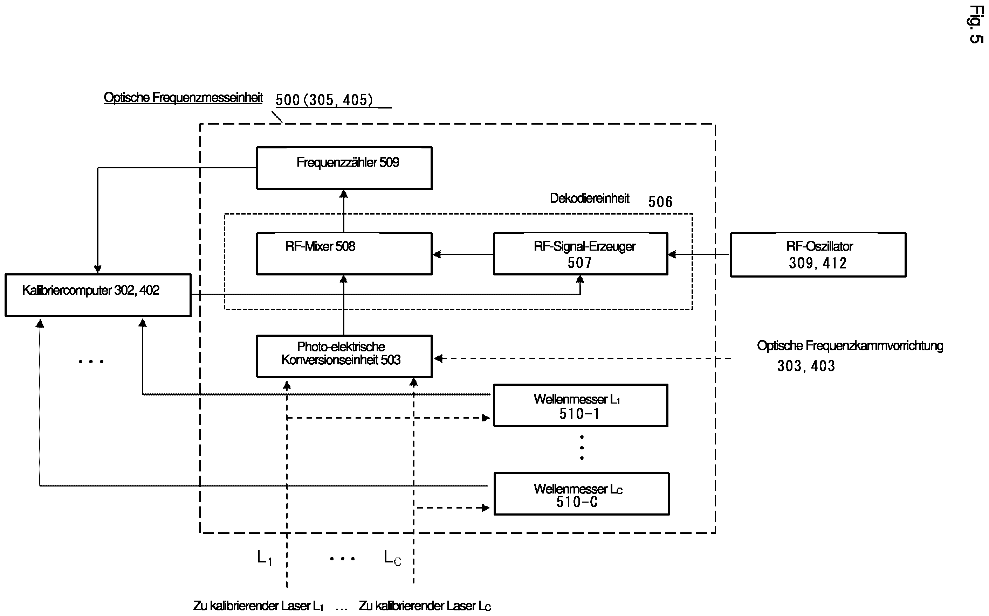

Fig. 5 ist ein Blockbild, das den schematischen Aufbau einer Lichtfrequenz-Messeinheit des vorliegenden Beispiels zeigt. Wie in Fig. 5 gezeigt, fungiert eine optische Frequenzmesseinheit (500) als die in Fig. 3 gezeigte optische Frequenzmessvorrichtung (305) oder die in Fig. 4 gezeigte optische Frequenzmessvorrichtung (405) (anders ausgedrückt, umfassen die optischen Frequenzmessvorrichtungen (305, 405) als konkreten Aufbau den Aufbau der in Fig. 5 gezeigten optischen Frequenzmesseinheit (500)) und kalibrieren die optische Frequenz des Ausgangslichts eines zu kalibrierenden Lasers aus C-Stück zu kalibrierenden Lasern von einem zu kalibrierenden Laser L_1 bis zu einem zu kalibrierenden Laser L_C. In Fig. 5 zeigen durchgezogene Pfeile ein elektrisches Signal und gestrichelte Pfeile ein optisches Signal.

Es wird davon ausgegangen, dass unter Anführung des Beispiels der i-ten Slave-Kalibrierkammer (200-i) in Fig. 2 alle betreffenden zu kalibrierenden Laser durch den betreffenden optischen Modulator aus den optischen Modulatoren i_1 (210-i-1) bis i_Mi (210-i-$M_i$) frequenzmoduliert sind. Es wird dafür gesorgt, dass das Ausgangslicht einer Mehrzahl von zu kalibrierenden Lasern und das Ausgangslicht der optischen Frequenzkammvorrichtungen (303, 403) z. B. in eine aus einem optischen Element und einem Silikon-Photo-Detektor bestehende photo-elektrische Konversionseinheit (503) einfällt und optisch interferiert, um ein elektrisches Schwebungssignal zu erhalten. Um aus diesem Schwebungssignal ein aus einem bestimmten zu kalibrierenden Laser herrührendes Schwebungssignal zu extrahieren, wird basierend auf einem Dekodierbefehl des Kalibriercomputers (302, 402) und dem RF-Oszillator (309, 412) in der Dekodiereinheit (506) eine Dekodierung ausgeführt.

In der Dekodiereinheit (506) wird durch einen RF-Signal-Erzeuger (507), der den RF-Oszillator (309, 412) als externe Uhr verwendet, ein RF-Signal erzeugt, dessen Frequenz sich zeitlich dem Dekodierbefehl entsprechend ändert, das mit der Schwebungssignalausgabe der photo-elektrischen Konversionseinheit (503) und einem RF-Mixer (508) multipliziert wird. Dadurch wird nur die ursprüngliche Schwebungsfrequenz des entsprechenden zu kalibrierenden Lasers zeitunabhängig innerhalb der Frequenzstabilität der Lichtquelle konstant.

Ein aus einem anderen zu kalibrierenden Laser herrührendes Schwebungssignal wird in einem RF-Mixer (508) mit einem Sprungmuster überlagert, das sich von dem für die Dekodierung erforderlichen Sprungmuster unterscheidet, und springt pro Zeitintervall eines Springens weiter zu einer anderen Frequenz. Durch einen Sprung-Zeitintervall, der ausreichend kürzer als die Gate-Zeit eines Frequenzzählers (509) ist, kann das SN-Verhältnis von Licht, das nicht Gegenstand der Kalibrierung ist, unterdrückt werden, sodass beim Messen mittels des Frequenzzählers nur die Schwebungsfrequenz angezeigt wird, die vom betreffenden zu kalibrierenden Laser herrührt. Außerdem wird ein Teil des Lichts eines zu kalibrierenden Lasers $L_1$ mittels eines Wellenmessers $L_1$ (510-1) gemessen, ..., ein Teil des Lichts eines zu kalibrierenden Lasers $L_C$ mittels eines Wellenmessers $L_C$ (510-C) gemessen, und durch die Ausgabe von Wellenlängeninformationen an den Kalibriercomputer (302, 402) zur Spezifizierung der Modenordnung der Kalibrierung verwendet.

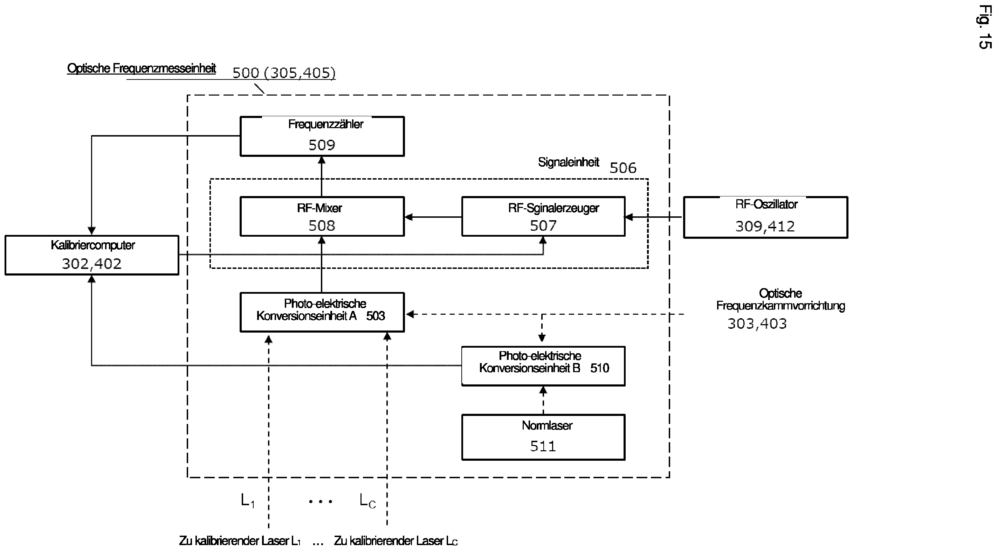

Als anderes Beispiel kann, wie in Fig. 15 gezeigt, dafür gesorgt werden, dass das Ausgangslicht einer Mehrzahl von zu kalibrierenden Lasern und das Ausgangslicht der optischen Frequenzkammvorrichtung (303, 403) z. B. in eine aus einem optischen Element und einem Silikon-Photo-Detektor bestehende photo-elektrische Konversionseinheit A (503) einfällt und optisch interferiert, um ein elektrisches Schwebungssignal zu erhalten. Ferner kann auch das Ausgangslicht eines Normlasers (511) (z. B. ein jodstabilisierter Helium-Neonlaser, ein acetylenstabilisierter Helium-Neon-Laser, eine optische Gitteruhr usw.), bei dem die Frequenzunsicherheit kleiner als der Modenabstand des optischen Frequenzkamms ist, und der optischen Frequenzkammvorrichtung (303, 403) durch eine photo-elektrische Konversionseinheit B (510) optisch interferiert, das Schwebungssignal erfasst und an den Kalibriercomputer (302, 402) ausgegeben werden, und dadurch für die Spezifizierung der Modenordnung der Kalibrierung verwendet werden.

6. Abwandlung der Lichtfrequenz-Messeinheit

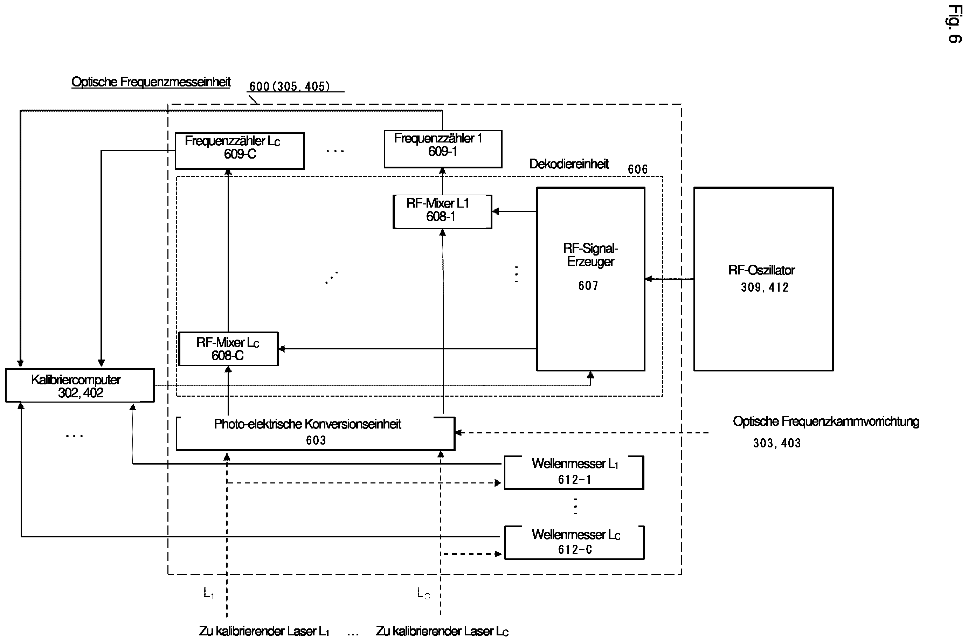

Fig. 6 ist ein Blockbild, das den schematischen Aufbau einer Lichtfrequenz-Messeinheit gemäß einer Abwandlung zeigt. Bei der vorliegenden Erfindung kann für die optische Frequenzmessvorrichtung (305, 405) anstelle der vorstehend beschriebenen optischen Frequenzmesseinheit (500) der in Fig. 6 gezeigte Aspekt verwendet werden. Eine in Fig. 6 gezeigte optische Frequenzmesseinheit (600) fungiert wie vorstehend als die in Fig. 3 gezeigte optische Frequenzmessvorrichtung (305) oder die in Fig. 4 gezeigte optische Frequenzmessvorrichtung (405) und kalibriert die optische Frequenz von C-Stück zu kalibrierenden Lasern aus C-Stück zu kalibrierenden Lasern von einem zu kalibrierenden Laser L_1 bis zu einem zu kalibrierenden Laser L_C. In Fig. 6 zeigen durchgezogene Pfeile ein elektrisches Signal und gestrichelte Pfeile ein optisches Signal.

Es wird davon ausgegangen, dass unter Anführung des Beispiels der i-ten Slave-Kalibrierkammer (200-i) in Fig. 2 alle betreffenden zu kalibrierenden Laser durch den betreffenden optischen Modulator aus den optischen Modulatoren i_1 (210-i-1) bis i_Mi (210-i-M_i) frequenzmoduliert sind. Es wird dafür gesorgt, dass das Ausgangslicht der zu kalibrierenden Laser und das Ausgangslicht der optischen Frequenzkammvorrichtungen (303, 403) z. B. in eine aus einem optischen Element und einem Silikon-Photo-Detektor bestehende photo-elektrische Konversionseinheit (603) einfällt und optisch interferiert, um ein elektrisches Schwebungssignal zu erhalten.

Um aus diesem Schwebungssignal ein aus einem bestimmten zu kalibrierenden Laser herrührendes Schwebungssignal zu extrahieren, wird basierend auf einem Dekodierbefehl des Kalibriercomputers (302, 402) und dem RF-Oszillator (309, 412) in der Dekodiereinheit (606) eine Dekodierung ausgeführt. In der Dekodiereinheit (606) werden durch einen oder eine Mehrzahl von RF-Signal-Erzeugern (607), die den RF-Oszillator (309, 412) als externe Uhr verwenden, ein oder eine Mehrzahl von RF-Signalen erzeugt, dessen/deren Frequenz sich zeitlich dem Dekodierbefehl entsprechend ändert, die Schwebungssignalausgabe der photo-elektrischen Konversionseinheit (603) aufgeteilt und mit den jeweiligen RF-Signalen jeweils mittels RF-Mixer L_1 (608-1) bis RF-Mixer L_c (608-C) multipliziert, und die RF-Frequenzen der entsprechenden RF-Mixerausgaben durch Frequenzzähler 1 (609-1) bis Frequenzzähler L_c (609-C) gemessen.

Dadurch wird nur die ursprüngliche Schwebungsfrequenz des zu kalibrierenden Lasers, das dem Dekodiermuster entspricht, das von den jeweiligen RF-Mixern angelegt wird, zeitunabhängig innerhalb der Frequenzstabilität der Lichtquelle konstant. Ein aus einem anderen zu kalibrierenden Laser herrührendes Schwebungssignal wird in dem betreffenden RF-Mixer mit einem Sprungmuster überlagert, das sich von dem für die Dekodierung erforderlichen Sprungmuster unterscheidet, und springt pro Zeitintervall eines Springens weiter zu einer anderen Frequenz. Durch einen Sprung-Zeitintervall, der ausreichend kürzer als die Gate-Zeit des betreffenden Frequenzzählers ist, kann das SN-Verhältnis von Licht, das nicht Gegenstand der Kalibrierung ist, unterdrückt werden, sodass beim Messen mittels des Frequenzzählers nur die Schwebungsfrequenz angezeigt wird, die vom betreffenden zu kalibrierenden Laser herrührt.

Außerdem wird ein Teil des Lichts eines zu kalibrierenden Lasers L_1 mittels eines Wellenmessers L_1 (612-1) gemessen, ..., ein Teil des Lichts eines zu kalibrierenden Lasers L_C mittels eines Wellenmessers L_C (612-C) gemessen, und durch die Ausgabe der erhaltenen optischen Frequenz an den Kalibriercomputer (302, 402) zur Spezifizierung der Modenordnung der Kalibrierung verwendet.

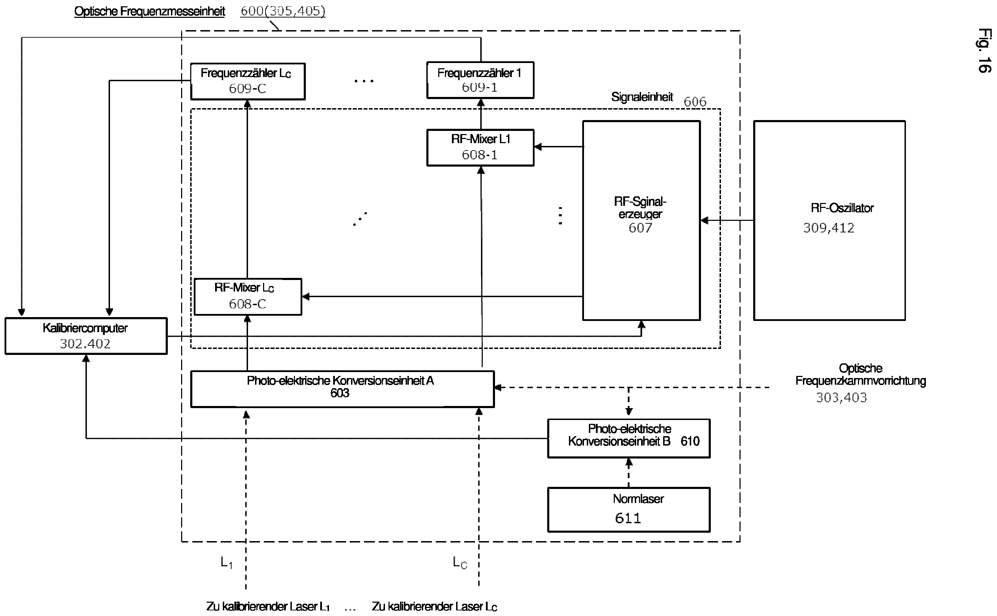

Als anderes Beispiel kann, wie in Fig. 16 gezeigt, dafür gesorgt werden, dass das Ausgangslicht der zu kalibrierenden Laser und das Ausgangslicht der optischen Frequenzkammvorrichtung (303, 403) z. B. in eine aus einem optischen Element und einem Silikon-Photo-Detektor bestehende photo-elektrische Konversionseinheit A (603) einfällt und optisch interferiert, um ein elektrisches Schwebungssignal zu erhalten. Ferner kann auch das Ausgangslicht eines Normlasers (611) (z. B. ein jodstabilisierter Helium-Neonlaser, ein acetylenstabilisierter Helium-Neon-Laser, eine optische Gitteruhr usw.), bei dem die Frequenzunsicherheit kleiner als der Modenabstand des optischen Frequenzkamms ist, und der optischen Frequenzkammvorrichtung (303, 403) durch eine photo-elektrische Konversionseinheit B (610) optisch interferiert, das Schwebungssignal erfasst und die erhaltene optische Frequenz an den Kalibriercomputer (302, 402) ausgegeben werden, und dadurch für die Spezifizierung der Modenordnung der Kalibrierung verwendet werden.

Durch das vorstehende Verfahren können mehrere Schwebungsfrequenzen, die aus einer einzigen photoelektrischen Konversionseinheit (603) (bei dem in Fig. 15 und dem in Fig. 16 gezeigten Beispiel die photoelektrische Konversionseinheit A) ausgegeben wurden, gleichzeitig wahlweise gemessen werden. Es handelt sich um ein Verfahren, bei dem durch eine Kombination mit dem unter Punkt 2 und 3 erläuterten Rahmenwerk gleichzeitig die optische Frequenz mehrerer zu kalibrierender Laser mittels einer einzigen optischen Frequenzkammvorrichtung kalibriert werden kann.

7. Handhabung des dezentralen Kalibriersystems

Ein konkretes Strukturbeispiel bezüglich des vorstehenden optischen Frequenzmessverfahrens ist in Fig. 7 dargestellt. Durchgezogene Pfeile zeigen ein elektrisches Signal und gestrichelte Pfeile zeigen ein optisches Signal. Bei diesem Beispiel wird der Fall beschrieben, dass die optische Frequenz des Ausgangslichts von zwei zu kalibrierenden Lasern, die in derselben Slave-Kalibrierkammer eingerichtet sind, selektiv gemessen wird. Das Ausgangslicht der beiden zu kalibrierenden Laser wird jeweils durch AOM1, AOM2 gebeugt. Die mit der Beugung einhergehende Verschiebungsgröße der optischen Frequenz ändert sich im Verlauf der Zeit und wird für jeden zu kalibrierenden Laser mit einem unterschiedlichen Sprungmuster $f_1(t)$, $f_2(t)$ gebeugt.

Hierbei ist die Ordnung der Beugung eine beliebige Ordnung ohne die 0-te Ordnung. Nachdem das mit $f_1(t)$, $f_2(t)$ kodierte Ausgangslicht der zu kalibrierenden Laser multiplext wurde und sich auf der gleichen optischen Faser ausbreitet, wird das Schwebungssignal des Ausgangslichts von zwei kodierten zu kalibrierenden Lasern und das Ausgangslicht des Offsetlasers z. B. in einer optischen Frequenzkammvorrichtung photoelektrisch konvertiert, und dann mit einem RF-Signal mit demselben Frequenzsprungmuster wie $f_1(t)$ elektrisch gemischt. Durch das Mischen bleibt nur die Schwebungsfrequenz des Ausgangslicht des zu kalibrierenden Lasers 1 und des Ausgangslichts des Offsetlasers ungeachtet der Zeit stets konstant (innerhalb der Frequenzstabilität des zu kalibrierenden Lasers).

Andererseits setzt sich bei der Schwebungsfrequenz des Ausgangslichts des zu kalibrierenden Lasers 1 und des Ausgangslichts des Offsetlasers stets ein Springen fort. Wenn für eine korrekte Durchführung der Frequenzmessung ein Aufbau verwendet wird, bei dem sich $f_1(t)$, $f_2(t)$ in einem ausreichend kürzeren Intervall als der Gate-Zeit des Frequenzzählers ändern, stimmt der Messwert des Frequenzzählers mit der Schwebungsfrequenz des Ausgabelichts des zu kalibrierenden Lasers 1 und des Ausgabelichts des Offsetlasers überein, wobei die Schwebungsfrequenz des Ausgangslichts des zu kalibrierenden Lasers 2 und des Ausgangslichts des Offsetlasers im zeitlichen Durchschnitt Null wird und daher ignoriert werden kann, und eine selektive Messung, d. h., Kalibrierung optischer Frequenzen möglich wird. Das vorliegende Verfahren ermöglicht ferner eine gleichzeitige Kalibrierung der optischen Frequenz des zu kalibrierenden Lasers 1 und der optischen Frequenz des zu kalibrierenden Lasers 2, wenn wie in Fig. 7 gezeigt, die Anzahl der Dekodierungselektronik hinzugefügt wird.

Vorstehend wurden konkrete Ausführungsformen der vorliegenden Erfindung erläutert, wobei die Aspekte, die bei der vorliegenden Erfindung anwendbar sind, nicht auf die vorstehend beschriebenen Aspekte beschränkt sind.

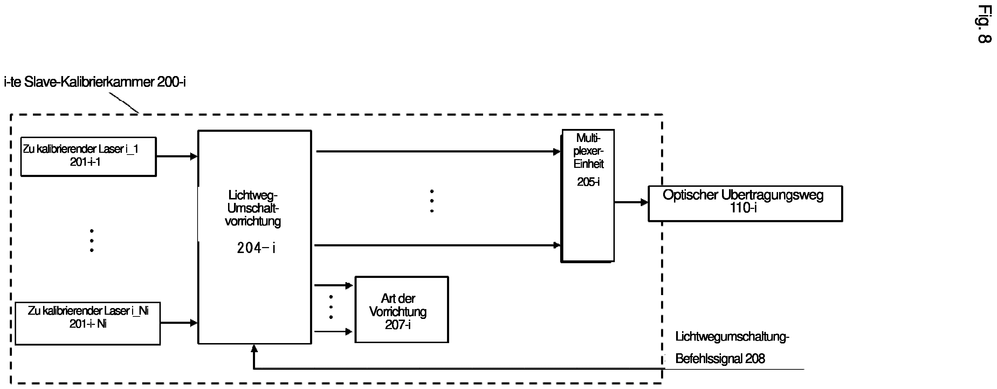

Beispielsweise ist bei dem vorstehenden Beispiel ein optischer Modulator i in einer Slave-Kalibrierkammer vorgesehen, und wenn von einer Master-Kalibrierkammer ein Kodierbefehlssignal gesendet wird, erfolgt basierend auf dem Modulationsmuster des Kodierbefehlssignals eine Frequenzmodulation der Phase oder Frequenz des Ausgangslichts einer Mehrzahl von zu kalibrierenden Lichtquellen mit jeweils unterschiedlichen Mustern, wobei keine Beschränkung auf diesen Aufbau besteht und auch ein Aufbau möglich ist, bei dem, wie in Fig. 8 gezeigt, der optische Modulator i weggelassen wurde. Bei dem Beispiel in Fig. 8 kann bei einem einzigen zu kalibrierenden Laser die Multiplexereinheit (205-i) auch weggelassen werden.

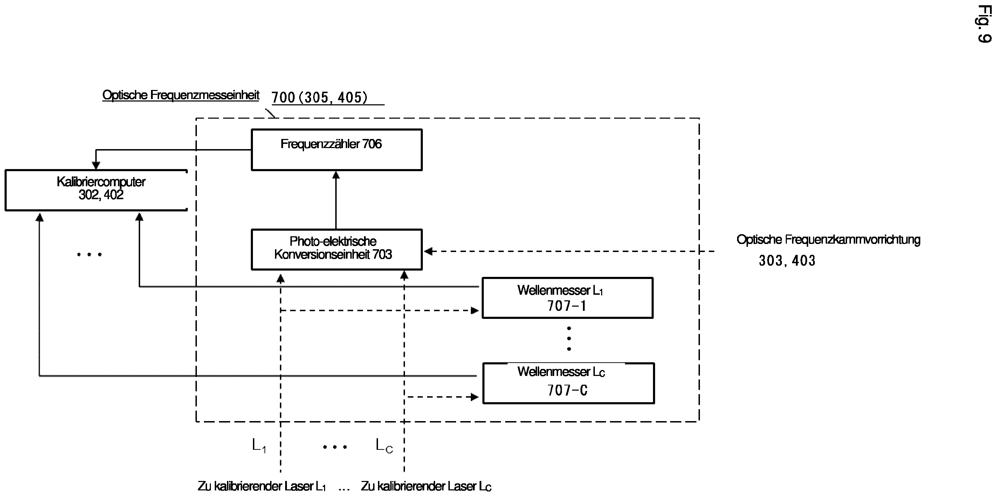

In diesem Fall kann für die optische Frequenzmessvorrichtung (305, 405) anstelle der vorstehend beschriebenen optischen Frequenzmesseinheit (500, 600) der in Fig. 9 gezeigte Aspekt verwendet werden. Fig. 9 ist ein Blockbild, das den schematischen Aufbau einer Lichtfrequenz-Messeinheit dieses Aspekts zeigt. Eine wie in Fig. 9 gezeigte optische Frequenzmesseinheit (700) fungiert ebenso wie vorstehend die in Fig. 3 gezeigte optische Frequenzmessvorrichtung (305) oder die in Fig. 4 gezeigte optische Frequenzmessvorrichtung (405) und kalibriert die optische Frequenz von einem zu kalibrierenden Lasern aus C-Stück zu kalibrierenden Lasern von einem zu kalibrierenden Laser L_1 bis zu einem zu kalibrierenden Laser L_C. In Fig. 9 zeigen durchgezogene Pfeile ein elektrisches Signal und gestrichelte Pfeile ein optisches Signal.

Hierbei wird davon ausgegangen, dass das gesamte Ausgangslicht der betreffenden zu kalibrierenden Laser über die Struktur, die das Beispiel der i-ten Slave-Kalibrierkammer (200-i) in Fig. 8 zeigt, an die Master-Kalibrierkammer übertragen wird. Wird das Ausgangslicht der zu kalibrierenden Laser an eine Mehrzahl von Master-Kalibrierkammern übertragen, wird dafür gesorgt, dass das Ausgangslicht von C-Stück zu kalibrierenden Lasern, die mittels einer Lichtweg-Umschaltvorrichtung der Master-Kalibrierkammer ausgewählt wurden, und das Ausgangslicht der optischen Frequenzkammvorrichtung (303, 403) z. B. in aus einem optischen Element und einem Silikon-Photo-Detektor bestehende C-Stück von photo-elektrischen Konversionseinheiten (703) einfällt und optisch interferiert, um ein elektrisches Schwebungssignal zu erhalten.

Die Frequenz des Schwebungssignals wird durch einen Frequenzzähler ausgelesen und für die Messung der optischen Frequenz verwendet.

Außerdem wird zur Festlegung der Modenordnung ein Teil des Ausgangslichts vom zu kalibrierenden Laser L_1 bis zum zu kalibrierenden Laser L_C abgezweigt, und durch einen Wellenmesser L_1 (707-1) bis L_C (707-C) wird die optische Frequenz mit einer Auflösung festgelegt, die höher ist als der Modenabstand des optischen Frequenzkamms (306, 406).

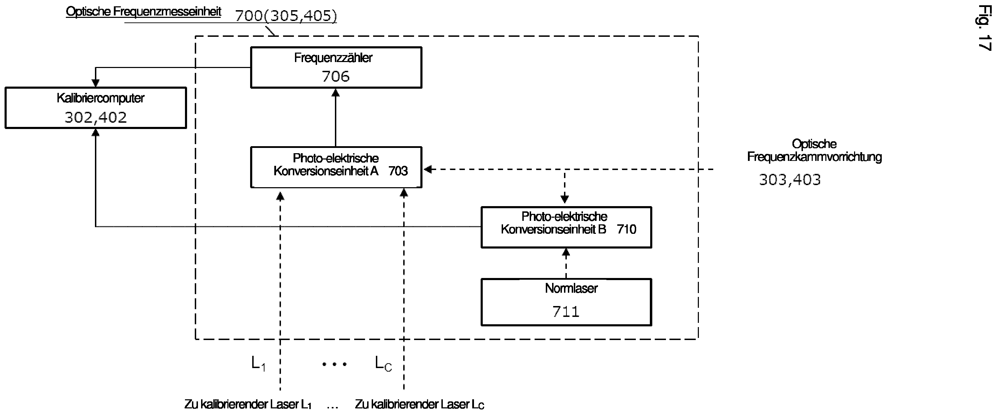

Wie als anderes Beispiel in Fig. 17 gezeigt, kann auch, wenn das Ausgangslicht der zu kalibrierenden Laser an eine Mehrzahl von Master-Kalibrierkammern übertragen wird, dafür gesorgt werden, dass das Ausgangslicht von C-Stück zu kalibrierenden Lasern, die mittels einer Lichtweg-Umschaltvorrichtung der Master-Kalibrierkammer ausgewählt wurden, und das Ausgangslicht der optischen Frequenzkammvorrichtung (303, 403) z. B. in aus einem optischen Element und einem Silikon-Photo-Detektor bestehende C-Stück von photo-elektrischen Konversionseinheiten A (703) einfällt und optisch interferiert, um ein elektrisches Schwebungssignal zu erhalten. Ferner kann zur Festlegung der Modenordnung auch das Ausgangslicht eines Normlasers (711) (z. B. ein jodstabilisierter Helium-Neonlaser, ein acetylenstabilisierter Helium-Neon-Laser, eine optische Gitteruhr usw.), bei dem die Frequenzunsicherheit kleiner als der Modenabstand des optischen Frequenzkamms ist, und der optischen Frequenzkammvorrichtung (303, 403) durch eine photo-elektrische Konversionseinheit B (710) optisch interferiert und das Schwebungssignal erfasst werden.

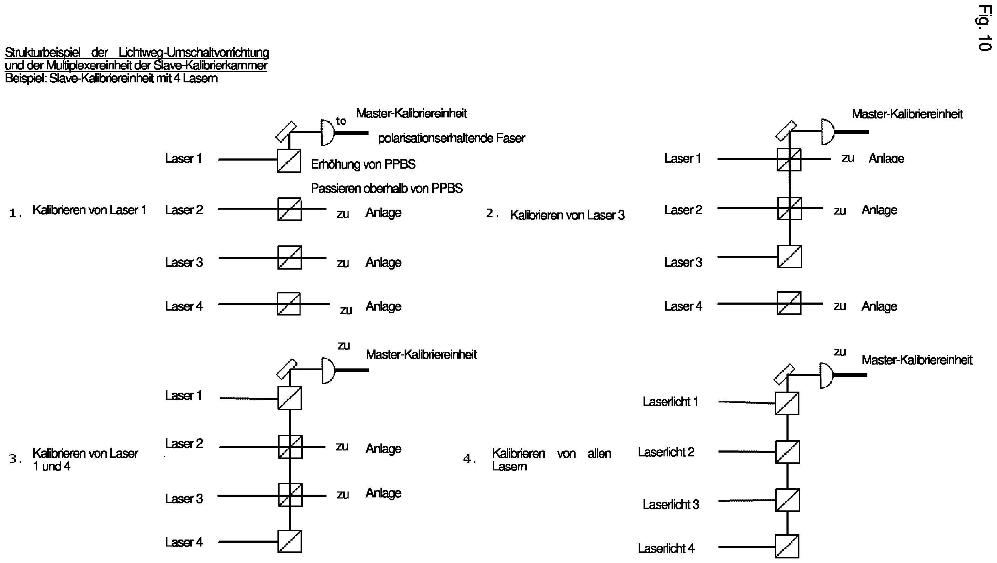

Ferner zeigt Fig. 10 ein konkretes Strukturbeispiel der Lichtweg-Umschaltvorrichtung (204-i) und der Multiplexereinheit (205-i) der Slave-Kalibrierkammer (200-i). Bei diesem Beispiel wird angenommen, dass es in einer in Fig. 2 dargestellten Slave-Kalibrierkammer (200-i) vier zu kalibrierende Laser 1 bis 4 gibt. Beim Kalibrieren des zu kalibrierenden Lasers 1 wird die Höhe eines teilweise polarisierenden Strahlteilers (PPBS, partially polarizing beam splitter), welcher derart angeordnet ist, das er mit dem Lichtweg des Ausgangslichts des zu kalibrierenden Lasers 1 keinen Kontakt hat, durch eine Antriebsstruktur wie ein Stellglied erhöht, und ein Teil des polarisierten Lichts des Ausgangslichts an der Stelle, an die es durch den PPBS reflektiert wurde, in einer Übertragungseinheit aus einem Übertragungsleiter wie einer polarisationserhaltenden Faser verbunden. In gleicher Weise kann beim gleichzeitigen Kalibrieren einer Mehrzahl von Lasern eine Ausführung angewendet werden, bei der eine Mehrzahl von PPBS, die sich unterhalb des Strahlenwegs der Mehrzahl von zu kalibrierenden Lasern befinden, erhöht werden, ein Teil des Ausgangslichts der Mehrzahl von zu kalibrierenden Lasern reflektiert wird, sodass die Teile zum gleichen Lichtweg gelangen, sich in einer Übertragungseinheit verbinden und an die Master-Kalibriereinheit übertragen werden. Es ist auch eine Ausführung denkbar, bei der dadurch, dass den jeweiligen PPBS durch eine Änderung von Filmbildungsbedingungen ein unterschiedlicher polarizierungslichtabhängiger Reflexionsgrad gegeben wird, alle zu kalibrierenden Laser, ungeachtet dessen, ob über eine Mehrzahl von PPBS oder nur über einen, mit der gleichen Stärke mit dem optischen Übertragungsweg verbunden werden. Wird ferner bei diesem Beispiel links von den PPBS in Fig. 10 ein optischer Modulator zugesetzt, kann bei den jeweiligen zu kalibrierenden Lasern eine unterschiedliche Modulation angewendet werden.

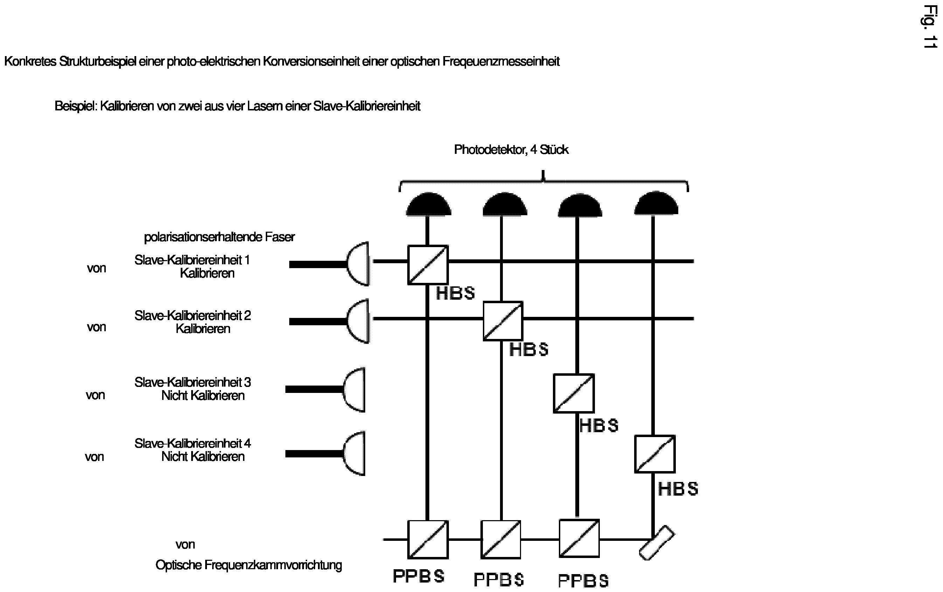

Ferner zeigt Fig. 11 ein konkretes Strukturbeispiel der Master-Lichtweg-Umschaltvorrichtung (304, 404) und der optischen Frequenz-Messvorrichtung (305, 405). Bei diesem Beispiel wird angenommen, dass von vier Slave-Kalibriereinheiten zwei zu kalibrierende Laser kalibriert werden. Das Ausgangslicht der optischen Frequenzkammvorrichtung wird wie vorstehend durch PPBS in vier Teile mit der gleichen Stärke geteilt, und ein durch ein Multiplexen des Ausgangslichts von der Slave-Kalibriereinheit 1 und eines Halbstrahlteilers (HBS, half-beam splitter) erzeugtes Schwebungssignal, wird durch einen Photodetektor photoelektrisch konvertiert und für die Frequenzmessung verwendet. In gleicher Weise wird bezüglich der Slave-Kalibriereinheit 2 ein Schwebungssignal des Ausgangslichts der optischen Frequenzkammvorrichtung, das durch einen anderen PPBS reflektiert wurde, durch einen anderen Photodetektor photoelektrisch konvertiert.

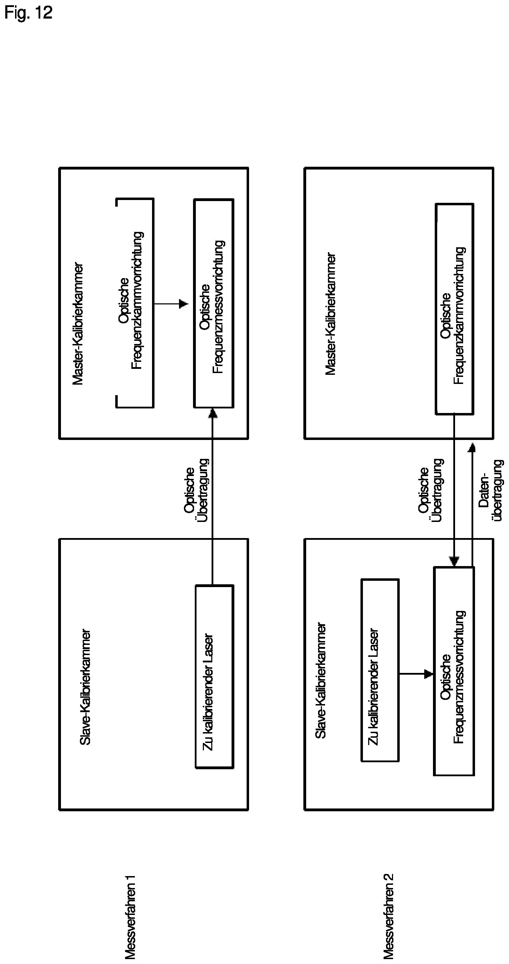

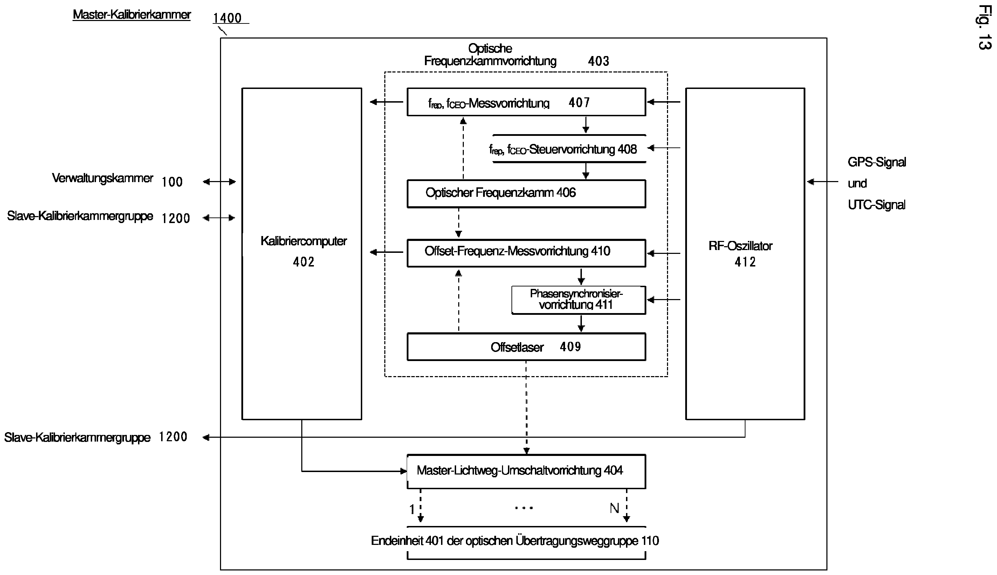

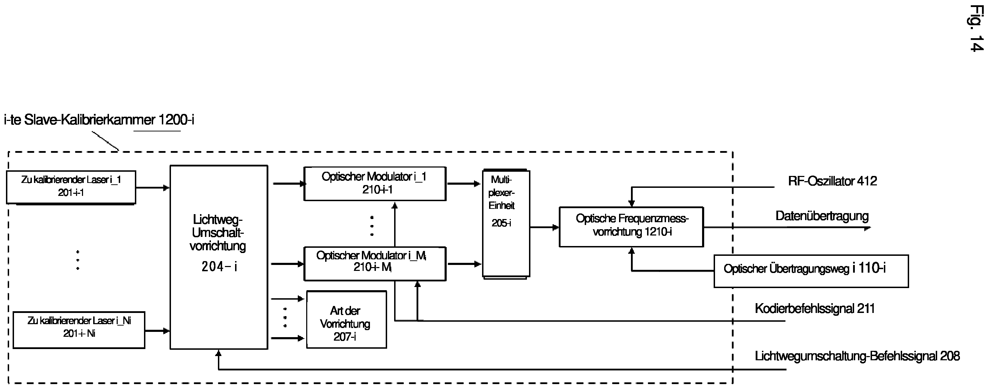

Ferner kann bei der vorliegenden Erfindung nicht nur das Verfahren, bei dem die optische Frequenzmessvorrichtung, die bei dem Messverfahren 1 in Fig. 12 dargestellt ist, in der Master-Kalibriereinheit eingerichtet ist, sondern auch ein Aspekt verwendet werden, bei dem die optische Frequenzmessvorrichtung, wie beim Messverfahren 2 gezeigt, in der Slave-Kalibriereinheit eingerichtet ist. In diesem Fall handelt es sich um eine Ausführung, bei der das Ausgangslicht der optischen Frequenzkammvorrichtung über eine Übertragungseinheit den jeweiligen Slave-Kalibriereinheiten zugeführt wird, Messfrequenzdaten, die durch die optische Frequenzmessvorrichtung erhalten wurden, die in der Slave-Kalibriereinheit eingerichtet ist, Messfrequenzdaten, die durch eine optische Interferenz eines Normlasers (z. B. ein jodstabilisierter Helium-Neonlaser, ein acetylenstabilisierter Helium-Neon-Laser, eine optische Gitteruhr usw.), bei dem die Frequenzunsicherheit ausreichend kleiner als der Modenabstand des optischen Frequenzkamms ist, und Schwebungsfrequenzdaten des Frequenzzählers an die Master-Kalibriereinheit übertragen werden. Fig. 13 ist ein Strukturbeispiel dafür, wenn eine Master-Kalibrierkammer (1400) von Fig. 4 entsprechend der Ausführung der Messmethode 2 in Fig. 12 geändert ist. Anders als bei Fig. 4 wird durch die Master-Lichtleiter-Umschaltvorrichtung (404) ausgewählt mit welchem Endabschnitt (401) der optischen Übertragungsweggruppe (110) das Ausgangslicht des Offsetlasers (409) verbunden wird, und dieses wird dann über den optischen Übertragungsweg an die Slave-Kalibriereinheit übertragen. Fig. 14 ist ein Strukturbeispiel dafür, wenn eine Slave-Kalibrierkammer (200-i) von Fig. 2 dem in Fig. 12 gezeigten Messmethode 2 folgend geändert ist. Bei einer solchen i-ten Slave-Kalibrierkammer (1200-i) wird das Schwebungssignal vom Ausgangslicht des Offsetlasers (409), das aus einer Master-Kalibrierkammer (1400) übertragen wurde, und dem Ausgangslicht der zum Gegenstand der Kalibrierung werdenden Laser von den zu kalibrierenden Lasern i_1 bis i_N_i, das von der Multiplexereinheit (205-i) ausgegeben wurde, in einer optischen Frequenz-Messvorrichtung (1210-i) gemessen, die in der i-ten Slave-Kalibrierkammer (1200-i) eingerichtet ist. Daten der gemessenen Schwebungsfrequenz werden an die Master-Kalibrierkammer (1400) übertragen und die Oszillationsfrequenz der zu kalibrierenden Laser wird durch den Kalibriercomputer (402) berechnet. Dabei wird die Ausgabe des RF-Oszillators (412) der Master-Kalibrierkammer (1400) einer Slave-Kalibrierkammergruppe (1200) zugeführt und für den Zeitgeber der optischen Frequenz-Messvorrichtung (1201-i) verwendet, die in der i-ten Slave-Kalibrierkammer (1200-i) in Fig. 14 eingerichtet ist. Die optische Frequenzmessvorrichtung (1210-i) hat im Übrigen die gleiche Funktion wie die optische Frequenzmessvorrichtungen (305, 405).

Bei der Erläuterung der vorstehend beschriebenen Ausführungsformen handelt es sich in sämtlichen Punkten um Beispiele, ohne dass eine Beschränkung hierauf besteht. Geeignete Abwandlungen und Änderungen von einem Fachmann sind möglich. Der Bereich der vorliegenden Erfindung ist nicht durch die vorstehenden Ausführungsformen, sondern in den Patentansprüchen dargestellt. Außerdem sind vom Bereich der Erfindung Änderungen von Ausführungsformen im Bereich der Ansprüche und einem diesem gleichgestellten Bereich umfasst.

## Erläuterung der Bezugszeichen

| | |
|---|---|
| 1 | Dezentrales Kalibriersystem |
| 100 | Verwaltungskammer |
| 110 | Optischer Übertragungsweg |
| 200 | Slave-Kalibrierkammergruppe |
| 204 | Lichtweg-Umschaltvorrichtung |
| 205 | Multiplexereinheit |
| 300 | Master-Kalibrierkammergruppe |
| 302 | Kalibriercomputer |
| 303 | Optische Frequenzkammvorrichtung |
| 305 | Optische Frequenzmessvorrichtung |
| 309 | RF-Oszillator |

## Patentansprüche

1. Fernkalibriersystem für optische Frequenzen, umfassend

mindestens eine Slave-Kalibriereinheit, die mit mindestens einer zu kalibrierenden Lichtquelle ausgestattet ist,
eine Master-Kalibriereinheit, die an einer Stelle eingerichtet ist, die von der Stelle, an der die zu kalibrierende Lichtquelle eingerichtet ist, entfernt ist, mit einer optischen Frequenzkammvorrichtung ausgestattet ist, und mittels der optischen Frequenzkammvorrichtung die optische Frequenz der zu kalibrierenden Lichtquelle, mit der die Slave-Kalibriereinheit ausgestattet ist, misst und kalibriert,
und eine optische Übertragungseinheit, welche die Slave-Kalibriereinheit und die Master-Kalibriereinheit verbindet,
wobei es sich um einen Aufbau handelt, bei dem die Master-Kalibriereinheit eine optische Frequenz des Ausgangslichts der zu kalibrierenden Lichtquelle der Slave-Kalibriereinheit, das über die optische Übertragungseinheit übertragen wurde, mittels einer elektrischen Ausgabe eines Schwebungssignals des Ausgangslichts der optischen Frequenzkammvorrichtung und des Ausgangslichts der zu kalibrierenden Lichtquelle beim Kalibrieren mittels der optischen Frequenzkammvorrichtung misst und kalibriert, und eine Funktion aufweist, um basierend auf einem auf der Basis von Zeit-und Frequenznormen fernkalibrierfähigen RF-Oszillator die Betriebsfrequenz der optischen Frequenzkammvorrichtung zu stabilisieren.

2. Fernkalibriersystem für optische Frequenzen, umfassend

mindestens eine Slave-Kalibriereinheit, die mit mindestens einer zu kalibrierenden Lichtquelle ausgestattet ist,
eine Master-Kalibriereinheit, die mit einer optischen Frequenzkammvorrichtung ausgestattet ist, und mittels der optischen Frequenzkammvorrichtung die optische Frequenz der zu kalibrierenden Lichtquellen, mit denen die Slave-Kalibrierkammer ausgestattet ist, zu messen und zu kalibrieren,
eine optische Übertragungseinheit, welche die Slave-Kalibriereinheit und die Master-Kalibriereinheit verbindet,
und eine Verwaltungseinheit mit der Funktion, einen Betriebszustand der Slave-Kalibriereinheit zu empfangen, der Funktion, einen Befehl zum Kalibrieren der zu kalibrierenden Lichtquelle an die Master-Kalibriereinheit zu senden, und der Funktion, ein Kalibrierergebnis von der Master-Kalibriereinheit zu empfangen,
wobei die Slave-Kalibriereinheit die Funktion, den Betriebszustand an die Verwaltungseinheit zu senden, die Funktion, ein Lichtweg-Umschaltsignal von der Master-Kalibriereinheit zu empfangen und die Funktion eines Verbindens mit dem Lichtleiter durch ein Umschalten des optischen Pfads des Ausgangslichts der zu kalibrierenden Lichtquelle hat,

und die Master-Kalibriereinheit die Funktion hat, wenn sie einen Kalibrierbefehl von der Verwaltungseinheit empfängt, einen Lichtweg-Umschaltbefehl an die Slave-Kalibriereinheit sendet und eine optische Frequenz des Ausgangslichts der zu kalibrierenden Lichtquelle, das von der Slave-Kalibriereinheit über den optischen Übertragungsweg übertragen wurde, mittels der optischen Frequenzkammvorrichtung kalibriert, unter Verwendung der elektrischen Ausgabe eines Schwebungssignals des Ausgangslichts der optischen Frequenzkammvorrichtung und des Ausgangslichts der zu kalibrierenden Lichtquelle die optische Frequenz zu messen und zu kalibrieren, die Funktion, ein Kalibrierergebnis an die Verwaltungskammer zu senden, und außerdem die Funktion hat, über GPS basierend auf einem auf der Basis von Zeit- und Frequenznormen fernkalibrierfähigen RF-Oszillator die Betriebsfrequenz der optischen Frequenzkammvorrichtung zu stabilisieren.

3. Fernkalibriersystem für optische Frequenzen, umfassend

mindestens eine Slave-Kalibriereinheit, die mit mindestens einer zu kalibrierenden Lichtquelle ausgestattet ist,

eine Master-Kalibriereinheit, die mit einer optischen Frequenzkammvorrichtung ausgestattet ist, und mittels der optischen Frequenzkammvorrichtung die optische Frequenz der zu kalibrierenden Lichtquellen, mit denen die Slave-Kalibrierkammer ausgestattet ist, zu messen und zu kalibrieren,

eine optische Übertragungseinheit, welche die Slave-Kalibriereinheit und die Master-Kalibriereinheit verbindet,

und eine Verwaltungseinheit mit der Funktion, einen Betriebszustand der Slave-Kalibriereinheit zu empfangen, der Funktion, einen Befehl zum Kalibrieren der zu kalibrierenden Lichtquelle an die Master-Kalibriereinheit zu senden, und der Funktion, ein Kalibrierergebnis von der Master-Kalibriereinheit zu empfangen,

wobei die Slave-Kalibriereinheit die Funktion, den Betriebszustand an die Verwaltungseinheit zu senden, die Funktion, ein Lichtweg-Umschaltsignal von der Master-Kalibriereinheit zu empfangen und die Funktion eines Verbindens mit dem Lichtleiter durch ein Umschalten des optischen Pfads des Ausgangslichts der zu kalibrierenden Lichtquelle hat,

und die Master-Kalibriereinheit die Funktion hat, wenn sie einen Kalibrierbefehl von der Verwaltungseinheit empfängt und einen Lichtweg-Umschaltbefehl an die Slave-Kalibriereinheit sendet, beim Kalibrieren einer optischen Frequenz des Ausgangslichts der zu kalibrierenden Lichtquelle, das von der Slave-Kalibriereinheit über den optischen Übertragungsweg übertragen wurde, mittels der optischen Frequenzkammvorrichtung, die den Offsetlaser umfasst, an den die Frequenzstabilität des optischen Frequenzkamms durch Phasensynchronisation übertragen wurde, unter Verwendung einer elektrischen Ausgabe eines Schwebungssignals des Ausgangslichts der optischen Frequenzkammvorrichtung und des Ausgangslichts der zu kalibrierenden Lichtquelle die optische Frequenz zu messen und zu kalibrieren, die Funktion, ein Kalibrierergebnis an die Verwaltungseinheit zu senden, und außerdem die Funktion hat, über GPS basierend auf einem auf der Basis von Zeit und Frequenznormen fernkalibrierfähigen RF-Oszillator die Betriebsfrequenz der optischen Frequenzkammvorrichtung zu stabilisieren.

Fig. 1

Fig. 2

EP 4 542 289 A1

i-te Slave-Kalibrierkammer 200-i

| Zu kalibrierender Laser i_1 201-i-1 |
| Zu kalibrierender Laser i_Ni 201-i- Ni |

Lichtweg-Umschalt-vorrichtung 204-i

Optischer Modulator i_1 210-i-1

Optischer Modulator i_Mi 210-i- Mi

Art der Vorrichtung 207-i

Multi-plexer-Einheit 205-i

Optischer Übertragungsweg 110-i

Kodierbefehlssignal 211

Lichtwegumschaltung-Befehlssignal 208

19

Fig. 3

GPS-Signal
und
UTC-Signal

Master-Kalibrierkammer 300

Optische Frequenzkammvorrichtung 303

RF-Oszillator 309

$f_{rep}, f_{CEO}$-Messvorrichtung 307

$f_{rep}, f_{CEO}$-Steuervorrichtung 308

Optischer Frequenzkamm 306

Optische Frequenzmessvorrichtung 305

Master-Lichtweg-Umschaltvorrichtung 304

Endeinheit 301 der optischen Übertragungsweggruppe 110

$L_1$ ... $L_c$ ... N

Kalibriercomputer 302

Verwaltungskammer 100

Slave-Kalibrierkammergruppe 200

Fig. 4

GPS-Signal
und
UTC-Signal

Master-Kalibrierkammer 400

Endeinheit 401 der optischen Übertragungsweggruppe 110

Optische Frequenzkammvorrichtung 403

RF-Oszillator 412

$f_{rep}, f_{CEO}$-Messvorrichtung 407

$f_{rep}, f_{CEO}$-Steuervorrichtung 408

Optischer Frequenzkamm 406

Offset-Frequenz-Messvorrichtung 410

Phasensynchronisier-vorrichtung 411

Offsetlaser 409

Optische Frequenzmessvorrichtung 405

Master-Lichtweg-Umschaltvorrichtung 404

$L_1$ ⋯ $L_{C_i}$ ⋯ N

1

Kalibriercomputer 402

Verwaltungskammer 100

Slave-Kalibrierkammergruppe 200

Fig. 5

Fig. 6

Fig. 7

EP 4 542 289 A1

Beispiel: Ausgangslicht des Offsetlasers

Kodierung

Dekodierung

Frequenzsprung

$: f_1(t)$

Ausgangslicht des
zu kalibrierenden Lasers 1

AOM1

RF-Signal

Optische
Faser

$f_2(t)$

Ausgangslicht des
zu kalibrierenden Lasers 2

AOM2

RF-Signal

RF-Signal
Frequenz: $f_3(t)$

Frequenzzähler

Ausgabe:
Schwebungssignal-frequenz
des Ausgangslichts des
zu kalibrierenden Lasers 1
und des Ausgangslichts des
Offsetlasers

Gleiches Muster

Gate-Zeit des
Frequenzzählers

Codierte
Frequenz $f_1(t)$
von AOM1

Zeit t

Codierte
Frequenz $f_2(t)$
von AOM2

Zeit t

Vom
Schwebungssignal
überlagerte
Dekodierfrequenz $f_3(t)$

Zeit t

24

Fig. 8

Optischer Übertragungsweg 110-i

Multi-plexer-Einheit 205-i

Lichtwegumschaltung-Befehlssignal 208

Art der Vorrichtung 207-i

Lichtweg-Umschalt-vorrichtung 204-i

i-te Slave-Kalibrierkammer 200-i

Zu kalibrierender Laser i_1 201-i-1

Zu kalibrierender Laser i_Ni 201-i-Ni

. . .

Fig. 9

Optische Frequenzkammvorrichtung
303, 403

Optische Frequenzmesseinheit  700 (305, 405)

Frequenzzähler 706

Photo-elektrische
Konversionseinheit 703

Wellenmesser L₁
707−1

· · ·

Wellenmesser Lᴄ
707−C

Kalibriercomputer
302, 402

L₁   · · ·   Lᴄ

Zu kalibrierender Laser L₁   ...   Zu kalibrierender Laser Lᴄ

Fig. 10

EP 4 542 289 A1

Strukturbeispiel der Lichtweg-Umschaltvorrichtung
und der Multiplexereinheit der Slave-Kalibrierkammer
Beispiel: Slave-Kalibriereinheit mit 4 Lasern

Fig. 11

EP 4 542 289 A1

Konkretes Strukturbeispiel einer photo-elektrischen Konversionseinheit einer optischen Freqeuenzmesseinheit

Beispiel: Kalibrieren von zwei aus vier Lasern einer Slave-Kalibriereinheit

Photodetektor, 4 Stück

polarisationserhaltende Faser

von   Slave-Kalibriereinheit 1
Kalibrieren

HBS

von   Slave-Kalibriereinheit 2
Kalibrieren

HBS

von   Slave-Kalibriereinheit 3
Nicht Kalibrieren

HBS

von   Slave-Kalibriereinheit 4
Nicht Kalibrieren

HBS

von

Optische Frequenzkammvorrichtung

PPBS   PPBS   PPBS

Fig. 12

**Messverfahren 1**

Slave-Kalibrierkammer

Zu kalibrierender Laser

Optische
Übertragung

Master-Kalibrierkammer

Optische
Frequenzkammvorrichtung

Optische
Frequenzmessvorrichtung

**Messverfahren 2**

Slave-Kalibrierkammer

Zu kalibrierender Laser

Optische
Frequenzmessvorrichtung

Optische
Übertragung

Datenübertragung

Master-Kalibrierkammer

Optische
Frequenzkammvorrichtung

Fig. 13

Master-Kalibrierkammer 1400

GPS-Signal und UTC-Signal

RF-Oszillator 412

Optische Frequenzkammvorrichtung 403

$f_{rep}$, $f_{CEO}$-Messvorrichtung 407

$f_{rep}$, $f_{CEO}$-Steuervorrichtung 408

Optischer Frequenzkamm 406

Offset-Frequenz-Messvorrichtung 410

Phasensynchronisiervorrichtung 411

Offsetlaser 409

Master-Lichtweg-Umschaltvorrichtung 404

Endeinheit 401 der optischen Übertragungsweggruppe 110

Kalibriercomputer 402

Verwaltungskammer 100

Slave-Kalibrierkammergruppe 1200

Slave-Kalibrierkammergruppe 1200

Fig. 14

i-te Slave-Kalibrierkammer 1200-i

Zu kalibrierender Laser i_1
201-i-1

· · ·

Zu kalibrierender Laser i_Ni
201-i-Ni

Lichtweg-
Umschalt-
vorrichtung
204 – i

Optischer Modulator i_1
210-i-1

· · ·

Optischer Modulator i_M
210-i-M

Art der
Vorrichtung
207-i

· · ·

Multi-
plexer-
Einheit
205-i

Optische Frequenzmessvorrichtung 1210-i

RF-Oszillator 412

Datenübertragung

Optischer Übertragungsweg i 110-i

Kodierbefehlssignal 211

Lichtwegumschaltung-Befehlssignal 208

Fig. 15

Optische Frequenzmesseinheit 500 (305,405)

RF-Oszillator 309,412

Optische Frequenzkammvorrichtung 303,403

Signaleinheit 506

RF-Sginalerzeuger 507

Frequenzzähler 509

RF-Mixer 508

Photo-elektrische Konversionseinheit A 503

Photo-elektrische Konversionseinheit B 510

Normlaser 511

Kalibriercomputer 302,402

Zu kalibrierender Laser $L_1$ ... Zu kalibrierender Laser $L_C$

$L_1$ ... $L_C$

Fig. 16

EP 4 542 289 A1

Optische Frequenzmesseinheit 700(305,405)

Frequenzzähler
706

Kalibriercomputer
302,402

Photo-elektrische
Konversionseinheit A   703

Optische
Frequenzkammvorrichtung
303,403

Photo-elektrische
Konversionseinheit B   710

Normlaser
711

$L_1$   $\cdots$   $L_C$

Zu kalibrierender Laser $L_1$   ...   Zu kalibrierender Laser $L_C$

Fig. 17

## INTERNATIONAL SEARCH REPORT

International application No.

**PCT/JP2024/028367**

### A. CLASSIFICATION OF SUBJECT MATTER

*G02F 1/01*(2006.01)i; *G01J 9/02*(2006.01)i; *H01S 3/00*(2006.01)i; *H01S 3/137*(2006.01)i
FI: G02F1/01 B; G01J9/02; H01S3/137; H01S3/00 G

According to International Patent Classification (IPC) or to both national classification and IPC

### B. FIELDS SEARCHED

Minimum documentation searched (classification system followed by classification symbols)

G02F1/00-1/125; G02F1/21-7/00; G01J3/00-4/04; G01J7/00-9/04; H01S3/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2012-004426 A (MITSUTOYO CORP.) 05 January 2012 (2012-01-05) entire text, all drawings | 1-3 |
| A | JP 2012-038833 A (MITSUTOYO CORP.) 23 February 2012 (2012-02-23) entire text, all drawings | 1-3 |
| A | JP 2013-072848 A (MITSUTOYO CORP.) 22 April 2013 (2013-04-22) entire text, all drawings | 1-3 |
| A | JP 2014-190759 A (MITSUTOYO CORP.) 06 October 2014 (2014-10-06) entire text, all drawings | 1-3 |
| A | JP 2015-005601 A (MITSUTOYO CORP.) 08 January 2015 (2015-01-08) entire text, all drawings | 1-3 |
| A | JP 2016-211965 A (MITSUTOYO CORP.) 15 December 2016 (2016-12-15) entire text, all drawings | 1-3 |

☑ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 October 2024** | **29 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

| | International application No. |
|---|---|
| | **PCT/JP2024/028367** |

**C.     DOCUMENTS CONSIDERED TO BE RELEVANT**

| Category* | Citation of document, with indication, where appropriate, of the relevant passages | Relevant to claim No. |
|---|---|---|
| A | US 9287993 B1 (THE UNITED STATES OF AMERICA AS REPRESENTED BY THE SECRETARY OF THE NAVY) 15 March 2016 (2016-03-15) entire text, all drawings | 1-3 |
| A | EP 3327411 A1 (AIRBUS DEFENCE AND SPACE GMBH) 30 May 2018 (2018-05-30) entire text, all drawings | 1-3 |

Form PCT/ISA/210 (second sheet) (July 2022)

International application No.

**PCT/JP2024/028367**

| Patent document cited in search report | | | Publication date (day/month/year) | Patent family member(s) | Publication date (day/month/year) |
|---|---|---|---|---|---|
| JP | 2012-004426 | A | 05 January 2012 | (Family: none) | |
| JP | 2012-038833 | A | 23 February 2012 | (Family: none) | |
| JP | 2013-072848 | A | 22 April 2013 | (Family: none) | |
| JP | 2014-190759 | A | 06 October 2014 | (Family: none) | |
| JP | 2015-005601 | A | 08 January 2015 | (Family: none) | |
| JP | 2016-211965 | A | 15 December 2016 | (Family: none) | |
| US | 9287993 | B1 | 15 March 2016 | (Family: none) | |
| EP | 3327411 | A1 | 30 May 2018 | (Family: none) | |

Form PCT/ISA/210 (patent family annex) (July 2022)

**IN DER BESCHREIBUNG AUFGEFÜHRTE DOKUMENTE**

**In der Beschreibung aufgeführte Patentdokumente**

- JP 2015005601 A
- JP 2014190759 A

**In der Beschreibung aufgeführte Nicht-Patentliteratur**

- **HAJIME INABA et al.** Frequency Measurement Capability of a Fiber-Based Frequency Comb at 633 nm. *IEEE TRANSACTIONS ON INSTRUMEN-TATION AND MEASUREMENT*, April 2009, vol. 58 (4), 1234